# EUROPEAN PATENT APPLICATION

(11) **EP 4 459 013 A1**
(43) Date of publication of application: **06.11.2024**
(21) Application number: 22914460.5
(22) Date of filing: 21.12.2022
(51) Int. Cl.: C30B 29/06, C30B 15/20

(54) **METHOD FOR PREPARING SINGLE CRYSTAL, AND SILICON CRYSTAL**

(30) Priority: 27.12.2021 CN 202111619092; 27.12.2021 CN 202111619103
(71) Applicant: Zhonghuan Advanced Semiconductor Technology Co., Ltd., Wuxi, Jiangsu 214203 (CN)
(72) Inventor: WANG, Shuangli, Xuzhou, Jiangsu 221004 (CN); CHEN, Chun-hung, Xuzhou, Jiangsu 221004 (CN); WU, Wei, Xuzhou, Jiangsu 221004 (CN)
(74) Representative: Zacco GmbH
(86) International application number: PCT/CN2022/140778
(87) International publication number: WO 2023/125206

(57) **Abstract**

A method for preparing a single crystal, and a silicon crystal, the preparation method includes: in an equal-diameter growth stage, obtaining Gₕ according to a linear equation Gₕ=k*h+G₀, where G₀ is a temperature gradient at a solid-liquid interface, with a value being 35 to 55 K/cm, k is a constant, h is a height relative to the solid-liquid interface, with a value being 0 to 10 mm, and Gₕ is an axial temperature gradient of a crystal ingot at the height h from the solid-liquid interface, the unit is K/cm; and adjusting a temperature gradient to Gₕ in an area from the solid-liquid interface to a first reference plane. The first reference plane is an interface 10 mm above the solid-liquid interface. By means of the method, the concentrations of free V-type point defects and I-type point defects are reduced.

## Description

### Cross-Reference to Related Application

The present disclosure claims priorities to Chinese patent disclosure No. 202111619092.8 and Chinese patent disclosure No. 202111619103.2 which filed to the China National Intellectual Property Administration on December 27, 2021 and entitled "Method for Preparing Single Crystal, and Silicon Crystal" respectively, the disclosures of which are hereby incorporated by reference in their entireties.

### Technical Field

The present disclosure belongs to the field of semiconductors, and specifically relate to a method for preparing a single crystal, and a silicon crystal.

### Background

Voronkov proposed the V/G theory, which is specifically a ratio of a pulling speed to a temperature gradient G near a crystal growth interface in a pulling direction, i.e., there is a critical value of V/G during a crystal growth process. When the V/G ratio is less than the critical value, the concentration of interstitial type point defects (I-type point defects) is higher than that of vacancy type point defects (V-type point defects), and excessive I-type point defects remain in a crystal, such that the crystal is called an I-type silicon crystal; when the V/G ratio is greater than the critical value, the concentration of the interstitial type point defects (I-type point defects) is lower than that of the vacancy type point defects (V-type point defects), and excessive V-type point defects remain in the crystal, such that the crystal is called a V-type silicon crystal; and when the V/G ratio is equal to the critical value, the concentration of the I-type point defects and the V-type point defects remaining in the crystal is very small, and the difference between the I-type point defects and the V-type point defects is not significant, such that the crystal is grown to a crystal with few point defects, i.e., a perfect crystal.

However, it is difficult to strictly control the V/G ratio at the critical value, i.e., controlling the concentration of the I-type point defects at a solid-liquid interface to be equivalent to the concentration of the V-type point defects.

Therefore, the existing techniques for preparing perfect crystals are yet to be explored.

### Summary

The present disclosure is intended to solve one of the technical problems in the related art at least to a certain extent. For this purpose, one of the objectives of the present disclosure is to provide a method for preparing a single crystal, and a silicon crystal. The method allows the point defects in a crystal to fully convection diffusion and recombination by adjusting and controlling an axial temperature gradient of a crystal ingot in an area from a solid-liquid interface to a reference plane, then the concentrations of free V-type point defects and I-type point defects are reduced.

According to an aspect of the present disclosure, the present disclosure provides a method for preparing a single crystal. According to embodiments of the present disclosure, the method includes the following operations.

In an equal-diameter growth stage, Gₕ is obtained according to a linear equation Gₕ=k*h+G₀, where G₀ is a temperature gradient at a solid-liquid interface, with a value being 35 to 55 K/cm, h is a height relative to the solid-liquid interface, with a value being 0 to 10 mm, k is a constant, and Gₕ is an axial temperature gradient of a crystal ingot at the height h from the solid-liquid interface, the unit is K/cm.

A temperature gradient is adjusted to Gₕ in an area from the solid-liquid interface to a first reference plane. The first reference plane is an interface 10 mm above the solid-liquid interface.

According to the crystal preparation method of the embodiments of the present disclosure, by adjusting and controlling the axial temperature gradient of the crystal ingot in the area from the solid-liquid interface to the reference plane, I-type point defects and V-type point defects formed during a crystal growth process are fully diffused and recombined in an area near the solid-liquid interface, such that a formation concentration of free point defects is reduced.

In addition, the method for preparing a single crystal according to the embodiments of the present disclosure may further include the following additional technical features.

In some embodiments of the present disclosure, in an initial period of the equal-diameter growth stage, Gₕ₁ is calculated by taking k=k₁, a pulling speed of a crystal ingot is adjusted to v₁ according to the Gₕ₁, and a gap is d₁, where the k₁, the v₁, and the d₁ meet: -0.12≤k₁≤-0.1, 0.4≤v₁≤0.8 mm/min, and 50≤d₁≤52 mm; in a mid-period of the equal-diameter growth stage, Gₕ₂ is calculated by taking k=k₂, the pulling speed of the crystal ingot is adjusted to v₂ according to the Gₕ₂, and the gap is d₂, where the k₂, the v₂, and the d₂ meet: -0.25≤k₂≤-0.23, 0.4≤v₂≤0.6 mm/min, and 52≤d₂≤53 mm; and in a later period of the equal-diameter growth stage, Gₕ₃ is calculated by taking k=k₃, the pulling speed of the crystal ingot is adjusted to v₃ according to the Gₕ₃, and the gap is d₃, where the k₃, the v₃, and the d₃ meet: -0.16≤k₃≤0.14, 0.6≤v₃≤0.8 mm/min, and 54≤d₃≤55 mm.

In some embodiments of the present disclosure, in the initial period of the equal-diameter growth stage, △G_{c} is controlled to be 0.2 to 1 K/cm, △Gₑ is controlled to be 5 to 10 K/cm, and Gᵣ is not greater than 6 K/cm; in the mid-period of the equal-diameter growth stage, the △G_{c} is controlled to be 2 to 6 K/cm, the △Gₑ is controlled to be 5 to 10 K/cm, and the Gᵣ is not greater than 10 K/cm; and in the later period of the equal-diameter growth stage, the △G_{c} is controlled to be 0.2 to 1 K/cm, the △Gₑ is controlled to be 5 to 10 K/cm, and the Gᵣ is not greater than 6 K/cm. A temperature gradient variation in the axial direction at a central position of the crystal ingot is the △G_{c}, a temperature gradient variation in the axial direction at an edge position of the crystal ingot is the △Gₑ, and a radial temperature gradient of the crystal ingot is the Gᵣ.

In some embodiments of the present disclosure, the method further includes adjusting a width of a temperature band on the crystal ingot, wherein the temperature band comprises a first temperature band, a second temperature band, and a third temperature band, the first temperature band ranges from 1685K to 1605K, the second temperature band ranges from 1605K to 1355K, and the third temperature band ranges from 1355K to 955K.

In some embodiments of the present disclosure, in the equal-diameter growth stage, within the range of the first temperature band, the width of the temperature band is adjusted according to a linear equation Dₓ =m*G₀+b, where the G₀ is a temperature gradient at the solid-liquid interface, with a value being 35 to 55 K/cm, and the Dₓ is the width of the temperature band, the unit is mm.

In some embodiments of the present disclosure, in the initial period of the equal-diameter growth stage, D₁ is calculated by taking m=m₁ and b=b₁, and a height of a gas flow-guide cylinder from the solid-liquid interface is adjusted according to the D₁, where -0.1≤m₁≤-0.09, and 9≤b₁≤9.1; in the later period of the equal-diameter growth stage, D₂ is calculated by taking m=m₂ and b=b₂, and the height of the gas flow-guide cylinder from the solid-liquid interface is adjusted according to the D₂, where -0.09≤m₂≤-0.05, and 7≤b₂≤8.5; and in the mid-period of the equal-diameter growth stage, the width D₃ of the temperature band in the mid-period is between the width D₁ of the temperature band in the initial period and the width D₂ of the temperature band.

In some embodiments of the present disclosure, in the equal-diameter growth stage, within the range of the second temperature band, the width of the temperature band is adjusted according to a linear equation D_{y}=m*G₀+b, where the G₀ is a temperature gradient at the solid-liquid interface, with a value being 35-55 K/cm, and the D_{y} is the width of the temperature band, the unit is mm.

In some embodiments of the present disclosure, in the initial period of the equal-diameter growth stage, D₄ is calculated by taking m=m₃ and b=b₃, and a distance between the water-cooling jacket and the outer wall of the crystal ingot or the cooling water flow in the water-cooling jacket is adjusted according to the D₄, where -0.27≤m₃≤-0.24, and 23.5≤b₃≤25.5; in the later period of the equal-diameter growth stage, D₅ is calculated by taking m=m₄ and b=b₄, and the distance between the water-cooling jacket and the outer wall of the crystal ingot or the cooling water flow in the water-cooling jacket is adjusted according to the D₅, where -0.1≤m₄≤-0.06, and 16.5≤b₄≤17.5; and in the mid-period of the equal-diameter growth stage, the width D₆ of the temperature band in the mid-period is between the width D₄ of the temperature band in the initial period and the width D₅ of the temperature band in the later period.

In some embodiments of the present disclosure, in the equal-diameter growth stage, within the range of the third temperature band, the width of the temperature band is adjusted according to a linear equation D_{z} =n*L+c, where the D_{z} is the width of the temperature band, the unit is mm, and L is a length of the crystal ingot, the unit is mm.

In some embodiments of the present disclosure, in the initial period of the equal-diameter growth stage, D₇ is calculated by taking n=n₁ and c=c₁, and cooling water flow in the water-cooling jacket is adjusted according to the D₇, where -0.035≤n₁≤-0.015, and 35≤c₁≤45; and in the mid-period and later period of the equal-diameter growth stage, the width of the temperature band is controlled to maintain unchanged, and the width D₈ of the temperature band in the mid-period is equal to the width D₇ of the temperature band in the initial period.

In some embodiments of the present disclosure, in the equal-diameter growth stage, G_{H} is obtained according to a linear equation G_{H}=A*H²+B*H+G₀, where A and B are constants, the G₀ is the temperature gradient at the solid-liquid interface, with the value being 35 to 55 K/cm, H is a height relative to the solid-liquid interface, with a value being -10 to 0 mm, and the G_{H} is an axial temperature gradient of a boundary layer at the height H from the solid-liquid interface, the unit is K/cm; and a temperature gradient is adjusted to the G_{H} in an area from the solid-liquid interface to a second reference plane. The second reference plane is an interface 10 mm below the solid-liquid interface. Therefore, by quantitatively controlling the axial temperature gradient in the areas above and below the solid-liquid interface, I-type point defects and V-type point defects formed during a crystal growth process are diffused and recombined at the solid-liquid interface, such that a formation concentration of the point defects is reduced, the size of microdefects is controlled, and a width of the perfect crystal window is increased. Furthermore, the method is particularly suitable for the growth of large-diameter crystal ingots, and the yield of perfect crystals of the large-diameter crystal ingots may be improved as well.

In some embodiments of the present disclosure, in an initial period of the equal-diameter growth stage, G_{H1} is calculated by taking A=A₁ and B=B₁, Gₕ₁ is calculated by taking k=k₁, a pulling speed of the crystal ingot is adjusted to v₁ according to the G_{H1} and the Gₕ₁, and a gap is d₁, where the A₁, the B₁, the k₁, the v₁, and the d₁ meet: 0.03≤A₁≤0.05, -0.3≤B₁≤-0.1, -0.12≤k₁≤-0.1, 0.4≤v₁≤0.8 mm/min, and 50≤d₁≤52 mm.

In a mid-period of the equal-diameter growth stage, G_{H2} is calculated by taking A=A₂ and B=B₂, Gₕ₂ is calculated by taking k=k₂, the pulling speed of the crystal ingot is adjusted to v₂ according to the G_{H2} and the Gₕ₂, and the gap is d₂, where the A₂, the B₂, the k₂, the v₂, and the d₂ meet: 0.01≤A₂≤0.03, -0.2≤B₂≤-0.1, -0.25≤k₂≤-0.23, 0.4≤v₂≤0.6 mm/min, and 52≤d₂≤53 mm.

In a later period of the equal-diameter growth stage, G_{H3} is calculated by taking A=A₃ and B=B₃, Gₕ₃ is calculated by taking k=k₃, the pulling speed of the crystal ingot is adjusted to v₃ according to the G_{H3} and the Gₕ₃, and the gap is d₃, where the A₃, the B₃, the k₃, the v₃, and the d₃ meet: 0.01≤A₃≤0.03, -0.2≤B₃≤-0.1, -0.16≤k₃≤0.14, 0.6≤v₃≤0.8 mm/min, and 54≤d₃≤55 mm.

In some embodiments of the present disclosure, in the area from the solid-liquid interface to the second reference plane: in the initial period of the equal-diameter growth stage, a temperature gradient variation △G_{c} in the axial direction at a central position of the boundary layer is controlled to be 2 to 3 K/cm, and a temperature gradient variation △Gₑ in the axial direction at an edge position of the boundary layer is controlled to be 3.5 to 5.5 K/cm.

In the mid-period of the equal-diameter growth stage, the temperature gradient variation △G_{c} in the axial direction at the central position of the boundary layer is controlled to be 4 to 6 K/cm, and the temperature gradient variation △Gₑ in the axial direction at the edge position of the boundary layer is controlled to be not greater than 5.4 K/cm.

In the later period of the equal-diameter growth stage, the temperature gradient variation △G_{c} in the axial direction at the central position of the boundary layer is controlled to be 2 to 3 K/cm, and the temperature gradient variation △Gₑ in the axial direction at the edge position of the boundary layer is controlled to be 3.5 to 5.5 K/cm.

The boundary layer is located in the area from the solid-liquid interface to the second reference plane.

In some embodiments of the present disclosure, in the area from the solid-liquid interface to the second reference plane: in the initial period of the equal-diameter growth stage, a radial temperature gradient Gᵣ of the boundary layer is controlled to be not greater than 2 K/cm.

In the mid-period of the equal-diameter growth stage, a radial temperature gradient Gᵣ of the boundary layer is controlled to be not greater than 4 K/cm.

In the later period of the equal-diameter growth stage, a radial temperature gradient Gᵣ of the boundary layer is controlled to be not greater than 2 K/cm.

In some embodiments of the present disclosure, T_{L} is calculated according to an equation T_{L} = g*L³+f*L²+q*L+T₀, where g, f, and q are all constants, T₀ is an average temperature at a triple point, the unit is K/cm, L is a height relative to the solid-liquid interface, with a value being 0 to 300 mm, and T_{L} is a temperature of an area near the crystal ingot at the distance L from the solid-liquid interface, the unit is K/ cm.

The area near the crystal ingot is a central area between a wall of the crystal ingot and an inner wall of a water-cooling jacket.

In some embodiments of the present disclosure, T_{L1} is calculated by taking g=g₁, f=f₁, and q=q₁, and gas flow near the crystal ingot is adjusted according to the T_{L1}, where a value of g₁ is -8e^{-0.5} to -7e^{-0.5}, a value of f₁ is 0.0411 to 0.0477, and a value of q₁ is -10.309 to -9.6535.

According to another aspect of the present disclosure, the present disclosure provides a silicon crystal. According to the embodiments of the present disclosure, the silicon crystal is obtained through preparation by the above-mentioned method.

Additional aspects and advantages of the present disclosure will be partially set forth in the following description, and in part will be apparent from the following description, or may be learned by practice of the present disclosure.

### Brief Description of the Drawings

The above and/or additional aspects and advantages of the present disclosure become apparent and readily understood from the following description of the embodiments with reference to the following drawings.
Fig. 1 is a graph showing an axial temperature gradient Gₕ of a crystal ingot and a height h relative to the solid-liquid interface in an initial period of an equal-diameter growth stage (a length of the crystal ingot is 400 mm).
Fig. 2 is a graph showing an axial temperature gradient Gₕ of a crystal ingot and a height h relative to the solid-liquid interface in a mid-period of an equal-diameter growth stage (a length of the crystal ingot is 700 mm).
Fig. 3 is a graph showing an axial temperature gradient Gₕ of a crystal ingot and a height h relative to the solid-liquid interface in a later period of an equal-diameter growth stage (a length of the crystal ingot is 1000 mm).
Fig. 4 is a graph showing an axial temperature gradient Gₕ of a crystal ingot and a height h relative to the solid-liquid interface in a later period of an equal-diameter growth stage (a length of the crystal ingot being 1300 mm).
Fig. 5 is a graph showing the widths of temperature bands in an initial period and mid-period of an equal-diameter growth stage within a temperature band from 1685K to 1665K of a first temperature band.
Fig. 6 is a graph showing a width of a temperature band in a later period of an equal-diameter growth stage within a temperature band from 1685K to 1665K of a first temperature band.
Fig. 7 is a graph showing the widths of temperature bands in an initial period and mid-period of an equal-diameter growth stage within a temperature band from 1665K to 1645K of a first temperature band.
Fig. 8 is a graph showing a width of a temperature band in a later period of an equal-diameter growth stage within a temperature band from 1665K to 1645K of a first temperature band.
Fig. 9 is a graph showing the widths of temperature bands in an initial period and mid-period of an equal-diameter growth stage within a temperature band from 1645K to 1625K of a first temperature band.
Fig. 10 is a graph showing a width of a temperature band in a later period of an equal-diameter growth stage within a temperature band from 1645K to 1625K of a first temperature band.
Fig. 11 is a graph showing the widths of temperature bands in an initial period and mid-period of an equal-diameter growth stage within a temperature band from 1625K to 1605K of a first temperature band.
Fig. 12 is a graph showing a width of a temperature band in a later period of an equal-diameter growth stage within a temperature band from 1625K to 1605K of a first temperature band.
Fig. 13 is a schematic diagram of a solid-liquid interface and a boundary layer during the crystal growth process.
Fig. 14 is a graph showing an axial temperature gradient G_{H} near a solid-liquid interface and a height H relative to the solid-liquid interface, in an initial period of an equal-diameter growth stage (a length of the crystal ingot is 400 mm).
Fig. 15 is a graph showing an axial temperature gradient G_{H} near a solid-liquid interface and a height H relative to the solid-liquid interface, in a mid-period of an equal-diameter growth stage (a length of the crystal ingot is 700 mm).
Fig. 16 is a graph showing an axial temperature gradient G_{H} near a solid-liquid interface and a height H relative to the solid-liquid interface in a later period of an equal-diameter growth stage (a length of the crystal ingot is 1000 mm).
Fig. 17 is a graph showing an axial temperature gradient G_{H} near a solid-liquid interface and a height H relative to the solid-liquid interface in a later period of an equal-diameter growth stage (a length of the crystal ingot is 1300 mm).
Fig. 18 is a graph showing a temperature T_{L} near a crystal ingot at a distance L from a solid-liquid interface and a height L relative to the solid-liquid interface in an initial period of an equal-diameter growth stage (a length of the crystal ingot is 400 mm).
Fig. 19 is a graph showing a temperature T_{L} near a crystal ingot at a distance L from a solid-liquid interface and a height L relative to the solid-liquid interface in a mid-period of an equal-diameter growth stage (a length of the crystal ingot is 700 mm).
Fig. 20 is a graph showing a temperature T_{L} near a crystal ingot at a distance L from the solid-liquid interface and a height L relative to the solid-liquid interface in a later period of an equal-diameter growth stage (a length of the crystal ingot is 1000 mm).
Fig. 21 is a graph showing a temperature T_{L} near a crystal ingot at a distance L from the solid-liquid interface and a height L relative to the solid-liquid interface in a later period of an equal-diameter growth stage (a length of the crystal ingot is 1300 mm).
Fig. 22 is a schematic diagram of specific operations of the copper decoration characterization method.

### Detailed Description of the Embodiments

The following detailed description of embodiments of the present disclosure is intended to explain the present disclosure and is not to be construed as a limitation of the present disclosure.

In the present disclosure, unless otherwise indicated, the following belongs to, and the meaning indicated by, the symbols are as defined below: the gap is a distance between a lower end of a gas flow-guide cylinder and a solid-liquid interface. The term "perfect crystal" as used herein does not mean an absolutely perfect crystal or a crystal without any defects, but allows for the presence of a small number of one or more defects, which are not sufficient to cause a significant change in some electrical or mechanical characteristic of the crystal or the wafer, which can lead to deterioration of the performance of an electronic device.

The Czochralski method for preparing a crystal includes putting a raw material polycrystalline silicon into a quartz crucible, then heating the quartz crucible to melt the polycrystalline silicon in the quartz crucible, then inserting a seed crystal into a surface of the melt for fusion, rotating the seed crystal at the same time, then reversing the crucible to make the seed crystal rise upward slowly, and the crystal ingot is prepared through processes such as seeding, amplification, shoulder rotation, equal-diameter growth, finishing, etc. In addition, during the process of preparing a crystal by Czochralski method, the thermal history in the crystal ingot is directly related to the distribution, type, and size of crystal defects, and the present disclosure is intended to make point defects in a crystal fully subjected to convective diffusion and recombination, and reduce the concentrations of free V-type point defects and I-type point defects.

For this purpose, according to an aspect of the present disclosure, the present disclosure provides a method for preparing a single crystal. According to embodiments of the present disclosure, the method includes: in an equal-diameter growth stage, obtaining Gₕ according to a linear equation Gₕ=k*h+G₀, where G₀ is a temperature gradient at a solid-liquid interface, with a value being 35 to 55 K/cm, k is a constant, h is a height relative to the solid-liquid interface, with a value being 0 to 10 mm, and Gₕ is an axial temperature gradient of a crystal ingot at the height h from the solid-liquid interface, the unit is K/cm; and adjusting a temperature gradient to Gₕ in a region from the solid-liquid interface to the first reference plane. The first reference plane is an interface 10 mm above the solid-liquid interface. Therefore, by controlling the axial temperature gradient of the crystal ingot in the region from the solid-liquid interface to the first reference plane, I-type point defects and V-type point defects formed during a crystal growth process are fully diffused and recombined in a region near the solid-liquid interface, thereby reducing the formation concentration of point defects.

According to the embodiments of the present disclosure, in order to accurately control the temperature gradient of the crystal ingot in the region from the solid-liquid interface to the first reference plane, the present disclosure separately controls an initial period of the equal-diameter growth stage, a mid-period of the equal-diameter growth stage, and a later period of the equal-diameter growth stage. It is to be noted that, "the initial period of the equal-diameter growth stage" is defined as the stage that the length of the grown crystal is not greater than 400 mm; "the mid-period of the equal-diameter growth stage" is defined as the stage that the length of the grown crystal is greater than 400 mm and before the liquid level of a silicon melt in a crucible enters the R angle of a crucible; and "the later period of the equal-diameter growth stage" is defined as a stage after the liquid level of the silicon melt in the crucible enters the R angle of the crucible.

Specifically, in the initial period of the equal-diameter growth stage, Gₕ₁ is calculated according to the linear equation Gₕ=k*h+G₀, where k=k₁, a pulling speed of a crystal ingot is adjusted to be v₁ and a gap is adjusted to be d₁ according to the Gₕ₁ calculated, where the k₁, v₁, and d₁ meet: -0.12≤k₁≤-0.1, 0.4≤v₁≤0.8 mm/min, and 50≤d₁≤52 mm, i.e., a theoretical value of the Gₕ₁ is calculated according to the linear equation Gₕ=k*h+G₀, where k=k₁, and, then within corresponding ranges of the v₁ and d₁, by adjusting the pulling speed v₁ and the gap d₁, an actual value of the Gₕ₁ is equal to the theoretical value of the Gₕ₁. It may be understood that, when the actual value of the Gₕ₁ is less than the theoretical value, the gap d₁ is decreased to increase G₀, and the Gₕ₁ is close to the theoretical value, and at the same time, the pulling speed may be reduced within the range of the pulling speed v₁, so that point defects formed in the crystal have some time to fully diffuse and recombine, and then reduce the formation concentration of point defects. In the mid-period of the equal-diameter growth stage, Gₕ₂ is calculated according to the linear equation Gₕ= k*h+G₀, where k=k₂, according to the calculated Gₕ₂, the pulling speed of the crystal ingot is adjusted to be v₂ and the gap is adjusted to be d₂, where the k₂, v₂, and d₂ meet: -0.25≤k₂≤-0.23, 0.4≤v₂≤0.6 mm/min, and 52≤d₂≤53 mm, i.e., a theoretical value of the Gₕ₂ is calculated according to the linear equation Gₕ=k*h+G₀, where k=k₂, and then by adjusting the pulling speed v₂ and the gap d₂ within ranges corresponding to the v₂ and the d₂, an actual value of the Gₕ₂ is equal to the theoretical value of the Gₕ₂. It may be understood that, when the actual value of the Gₕ₂ is greater than the theoretical value, the gap d₂ is increased to reduce G₀, and the Gₕ₂ is close to the theoretical value, and at the same time, the pulling speed v₂ may be reduced within the range of the pulling speed, so that the point defects formed in the crystal have some time to fully diffuse and recombine, and then reduce the formation concentration of the point defects. In the later period of the equal-diameter growth stage, Gₕ₃ is calculated according to the linear equation Gₕ=k*h+G₀, where k=k₃, according to the calculated Gₕ₃ the pulling speed of the crystal ingot is adjusted to be v₃ and the gap is adjusted to be d₃, where the k₃, v₃, and d₃ meet: -0.16≤k₃≤0.14, 0.6≤v₃≤0.8 mm/min, and 54≤d₃≤55 mm, i.e., a theoretical value of the Gₕ₃ is calculated according to the linear equation Gₕ=k*h+G₀, where k= k₃, and then within corresponding ranges of the v₃ and the d₃, by adjusting the pulling speed v₃ and the gap d₃, an actual value of the Gₕ₃ is equal to the theoretical value of the Gₕ₃. It may be understood that, when the actual value of the Gₕ₃ is less than the theoretical value of the Gₕ₃, the gap d₃ is decreased to increase G₀, and the Gₕ₃ is close to the theoretical value, and at the same time, the pulling speed v₃ may be reduced within the range of the pulling speed, so that the point defects formed in the crystal have some time to fully diffuse and recombine, and reduce the formation concentration of point defects. Therefore, according to the preparation method, by respectively controlling the pulling speed and the gap in the initial period, mid-period, and later period of the equal-diameter growth stage, adjustment of the temperature gradient Gₕ in each period is realized, so that I-type point defects and V-type point defects formed during a growth process are fully diffused and recombined in a region near the solid-liquid interface, reducing the concentrations of the free V-type point defects and I-type point defects. In this way, the variation range of the pulling speed in a crystal growth stage may be increased by 10%, and the variation range of the gap may be increased by 5%, thereby expanding the adjustable window of process parameters and improving the crystal quality and the yield of perfect crystals. The yield is a ratio of the amount of a melted material for growing the perfect crystal to the amount of input material.

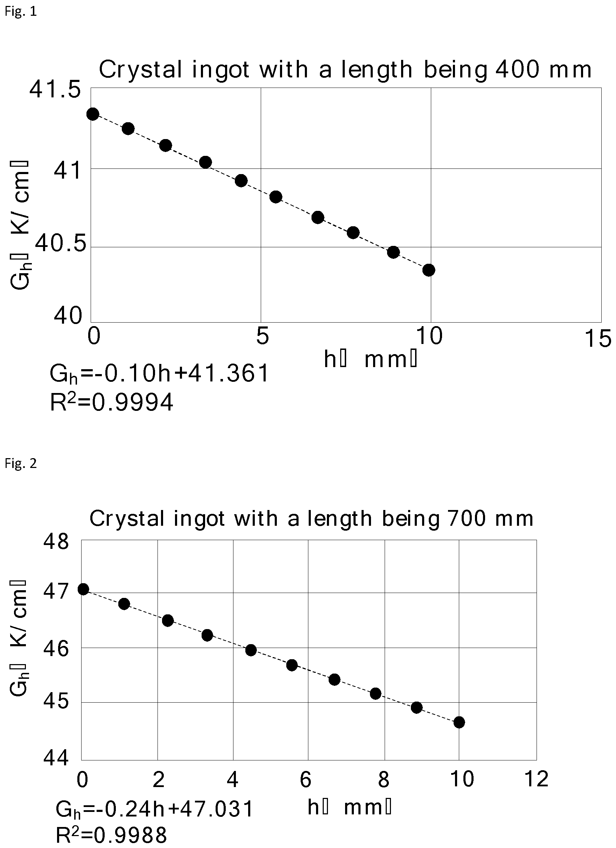

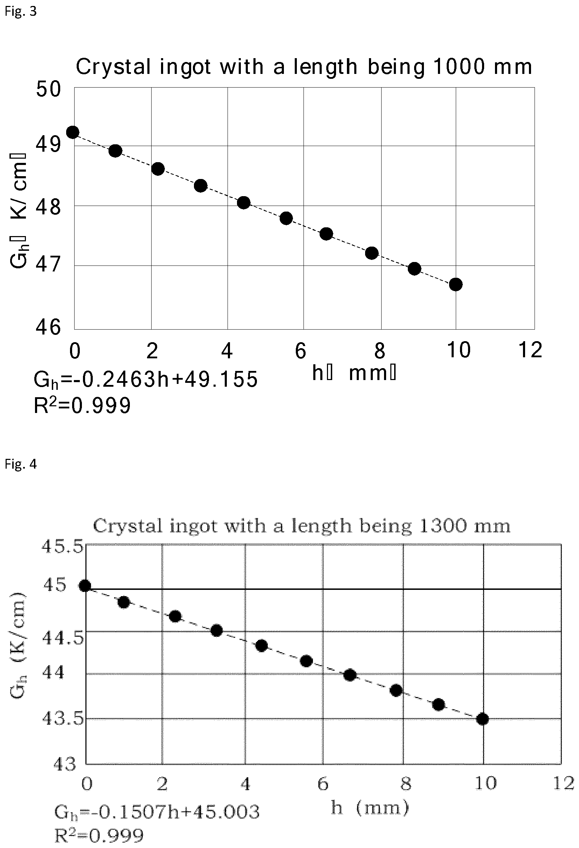

Further, in order to verify the fit performance of the linear equation, an axial temperature gradient of the crystal ingot in periods of different growth stages in the region from the crystal growing solid-liquid interface to the first reference plane are plotted relative to the height of the solid-liquid interface. As shown in Fig. 1, in the initial period of the equal-diameter growth stage (a length of the crystal ingot is 400 mm), a curve is plotted by using a height h relative to the crystal growing interface as the abscissa and using the axial temperature gradient Gₕ of the crystal ingot as an ordinate, a linear equation is Gₕ=-0.10h+41.361, and a fitting degree R² of the equation is 0.9994. As shown in Fig. 2, in the mid-period of the equal-diameter growth stage (the length of the crystal ingot being 700 mm), the curve is plotted by using the height h relative to the crystal growing interface as the abscissa and using the axial temperature gradient Gₕ of the crystal ingot as the ordinate, the linear equation is Gₕ=-0.24h+47.031, and the fitting degree R² of the equation is 0.9988. As shown in Figs. 3 and 4, in the later period of the equal-diameter growth stage (the lengths of the crystal ingots respectively are 1000 mm and 1300 mm), the curve is plotted by using the height h relative to the crystal growing interface as the abscissa and using the axial temperature gradient Gₕ of the crystal ingot as the ordinate, the linear equation corresponding to the length of the crystal ingot being 1000 mm is Gₕ=-0.2463h+49.155, the fitting degree R² of the equation is 0.999, the linear equation corresponding to the length of the crystal ingot being 1300 mm is Gₕ=-0.1507h+45.003, and the fitting degree R² of the equation is 0.999. In conclusion, the fitting degree of all linear equations is greater than 0.998, indicating that the fitted linear equation is very in line with actual situations, according to the linear equation, the axial temperature gradient in the region from the solid-liquid interface to the first reference plane may be accurately controlled by adjusting the pulling speed and the gap, so as to effectively reduce the formation concentration of the point defects.

According to the embodiments of the present disclosure, in order to further improve the quality of a crystal and the yield of perfect crystals, in the initial period of the equal-diameter growth stage, the temperature gradient variation △G_{c} in the axial direction at the central position of the crystal ingot is controlled to be 0.2 to 1 K/cm, the temperature gradient variation △Gₑ in the axial direction at an edge position of the crystal ingot is controlled to be 5 to 10 K/cm, and a radial temperature gradient Gᵣ of the crystal ingot is controlled to be not greater than 6 K/cm. In the mid-period of the equal-diameter growth stage, the temperature gradient variation △G_{c} in the axial direction of the central position is controlled to be 2 to 6 K/cm, the temperature gradient variation △Gₑ in the axial direction of the edge position is controlled to be 5 to 10 K/ cm, and the radial temperature gradient Gᵣ of the crystal ingot is controlled to be not greater than 10 K/cm. In the later period of the equal-diameter growth stage, the temperature gradient variation △G_{c} in the axial direction of the central position is controlled to be 0.2 to 1 K/cm, the temperature gradient variation △Gₑ in the axial direction of the edge position is controlled to be 5 to 10 K/cm, and the radial temperature gradient Gᵣ of the crystal ingot is controlled to be not greater than 6 K/cm. In this way, in different periods of the equal-diameter growth stage, by controlling the temperature gradient variations in the axial direction at the central position and edge position of the crystal ingot and the radial temperature gradient of the crystal ingot, it is guaranteed that the shape of the solid-liquid interface is similar to a plane, so that the axial temperature gradients in the same section are approximately uniform, and according to the V/G theory, the window for growing perfect crystals can be enlarged, thereby improving the yield of the perfect crystals.

According to the embodiments of the present disclosure, the method described in the present disclosure further includes adjusting a width of the temperature band from 1685K to 955K on the crystal ingot. The temperature band includes a first temperature band, a second temperature band, and a third temperature band. The first temperature band ranges from 1685K to 1605K. The second temperature band ranges from 1605K to 1355K. The third temperature band ranges from 1355K to 955K.

According to an embodiment of the present disclosure, the first temperature band includes temperature bands from 1685K to 1665K, 1665K to 1645K, 1645K to 1625K, and 1625K to 1605K. The first temperature band includes a several small temperature bands. The difference in the width of the small temperature bands is less than 1.0 mm, and the change in the width of the same temperature band during a growth process is less than 0.5 mm. During the growth process and within the range of the first temperature band in the equal-diameter growth stage, the width of the temperature band is adjusted according to a linear equation Dₓ=m*G₀+b. The G₀ is a temperature gradient at the solid-liquid interface, with a value being 35 to 55 K/cm. The Dₓ is the width of the temperature band, the unit is mm. It may be understood that, in the same period of the equal-diameter growth stage, by adjusting the width of the first temperature band according to the linear equation, the difference in the width of the small temperature bands in the first temperature band is less than 1.0 mm, that is to say, the width of the small temperature bands is similar. Meanwhile, in each period of the equal-diameter growth stage, the change in the width of each small temperature band is less than 0.5 mm, that is to say, a variation of the width of each small temperature band is small, such that the position of the width of the first temperature band on the crystal ingot can be accurately controlled.

Specifically, in the initial period of the equal-diameter growth stage, D₁ is calculated according to the linear equation Dₓ=m*G₀+b, where m=m₁ and b=b₁, and a height of the gas flow-guide cylinder from the solid-liquid interface is adjusted according to the D₁, where -0.1≤m₁≤-0.09 and 9≤b₁≤9.1, i.e., a theoretical value of the D₁ is calculated according to the linear equation Dₓ=m*G₀+b, where m=m₁ and b=b₁, and then by adjusting the height of the gas flow-guide cylinder from the solid-liquid interface, an actual value of the D₁ is equal to the theoretical value of the D₁. It may be understood that, adjustment of the temperature gradient G₀ at the solid-liquid interface is realized by adjusting the height of the gas flow-guide cylinder from the solid-liquid interface, so as to adjust the D₁. According to actual production situations, the height H of the gas flow-guide cylinder from the solid-liquid interface is increased by lowering a quartz crucible through rotation of the crucible shaft, and the quartz crucible is closer to the heater to reduce Go, and then the width D₁ of the temperature band increases. Likewise, the height H of the gas flow-guide cylinder from the solid-liquid interface is decreased by raising the quartz crucible through rotation of the crucible shaft, and the quartz crucible is far away from the heater to increase the Go, and then the width D₁ of the temperature band decreases. In the later period of the equal-diameter growth stage, D₂ is calculated according to the linear equation Dₓ=m*G₀+b, where m=m₂ and b=b₂, and the height of the gas flow-guide cylinder from the solid-liquid interface is adjusted according to the D₂, where -0.09≤m₂≤-0.05 and 7≤b₂≤8.5, i.e., a theoretical value of the D₂ is calculated according to the linear equation Dₓ=m*G₀+b, where m=m₂ and b =b₂, and then by adjusting the height of the gas flow-guide cylinder from the solid-liquid interface, an actual value of the D₂ is equal to the theoretical value of the D₂. It may be understood that, adjustment of the temperature gradient Go at the solid-liquid interface is realized by adjusting the height H of the gas flow-guide cylinder from the solid-liquid interface, so as to adjust the D₂. According to actual production situations, the height H of the gas flow-guide cylinder from the solid-liquid interface is increased by lowering the quartz crucible through rotation of the crucible shaft, so that the quartz crucible is closer to the heater to reduce the G₀, and the width D₂ of the temperature band increases. Likewise, the height H of the gas flow-guide cylinder from the solid-liquid interface is decreased by raising the quartz crucible through rotation of the crucible shaft, such that the quartz crucible is far away from the heater to increase the Go, and the width D₂ of the temperature band decreases. At the same time, in the mid-period of the equal-diameter growth stage, the width D₃ of the temperature band in the mid-period is between the width D₁ of the temperature band in the initial period and the width D₂ of the temperature band in the later period. During a process from the initial period to the later period via the mid-period, at a moment of transition from the initial period to the mid-period, the width D₃ of the temperature band in the mid-period is equal to the width D₁ of the temperature band in the initial period; and at a moment of transition from the mid-period to the later period, the width D₃ of the temperature band in the mid-period is equal to the width D₂ of the temperature band in the later period, and the width D₃ of the temperature band in the mid-period changes between the D₁ and the D₂. In conclusion, according to the linear equation of each period, the width of the first temperature band is timely adjusted by adjusting the height of the gas flow-guide cylinder from the solid-liquid interface, so that it is finally close to the theoretical value, and the temperature distribution of the crystal ingot is effectively controlled.

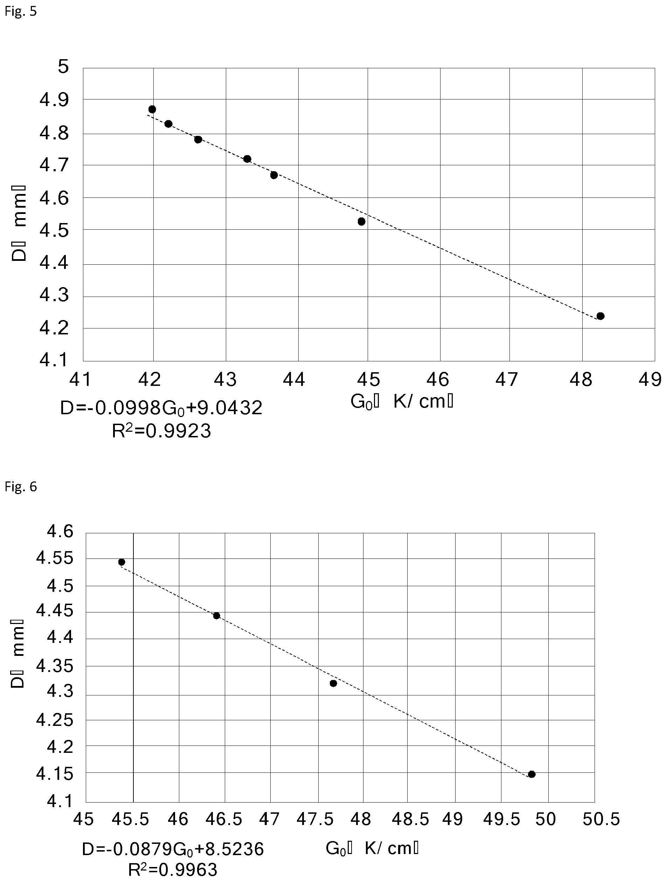

Specifically, within a temperature band from 1685K to 1665K of the first temperature band, Fig. 5 shows a curve of the temperature range in the initial period and mid-period of the equal-diameter growth stage, the linear equation of the width of the temperature band is Dₓ=-0.0998G₀+9.0432, and the fitting degree R² of the equation is 0.9923. Fig. 6 shows a curve of the width of the temperature band in the later period of the equal-diameter growth stage, the linear equation of the width of the temperature band is Dₓ = -0.0879G₀+8.5236, and the fitting degree R² of the equation is 0.9963. In the figure, the curve is plotted by taking the temperature gradient G₀ at the solid-liquid interface as the abscissa and taking the width Dₓ of the temperature band as the ordinate.

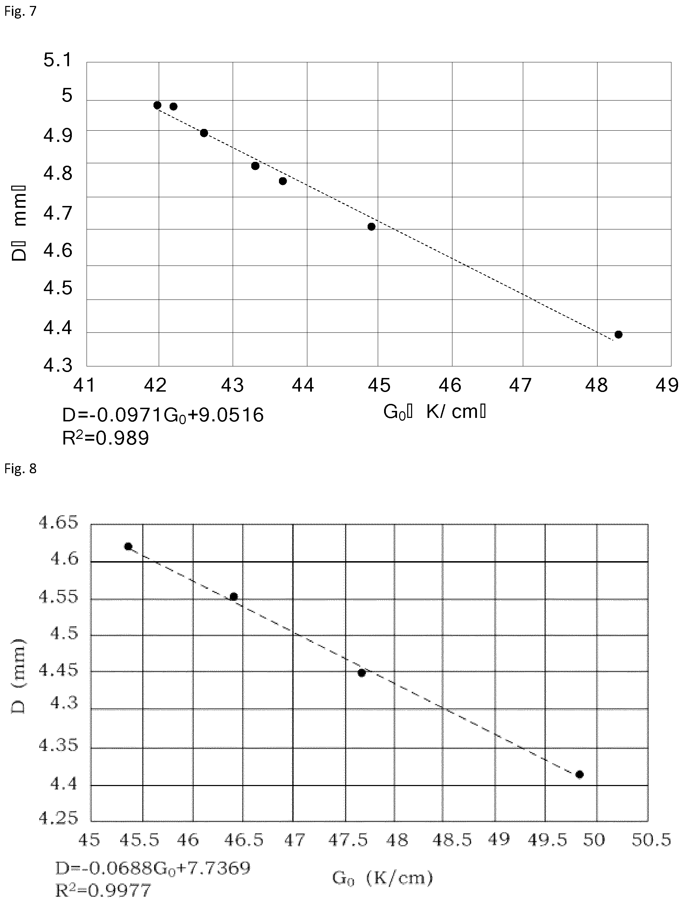

Specifically, within a temperature band from 1665K to 1645K of the first temperature band, Fig. 7 shows a curve of the temperature range in the initial period and mid-period of the equal-diameter growth stage, the linear equation of the width of the temperature band is Dₓ=-0.0971G₀+9.0516, and the fitting degree R² of the equation is 0.989. Fig. 8 shows a curve of the width of the temperature band in the later period of the equal-diameter growth stage, the linear equation of the width of the temperature band is Dₓ = -0.0688G₀+7.7369, and the fitting degree R² of the equation is 0.9977. In the figure, the temperature gradient G₀ at the solid-liquid interface is taken as the abscissa, and the width Dₓ of the temperature band is taken as the ordinate.

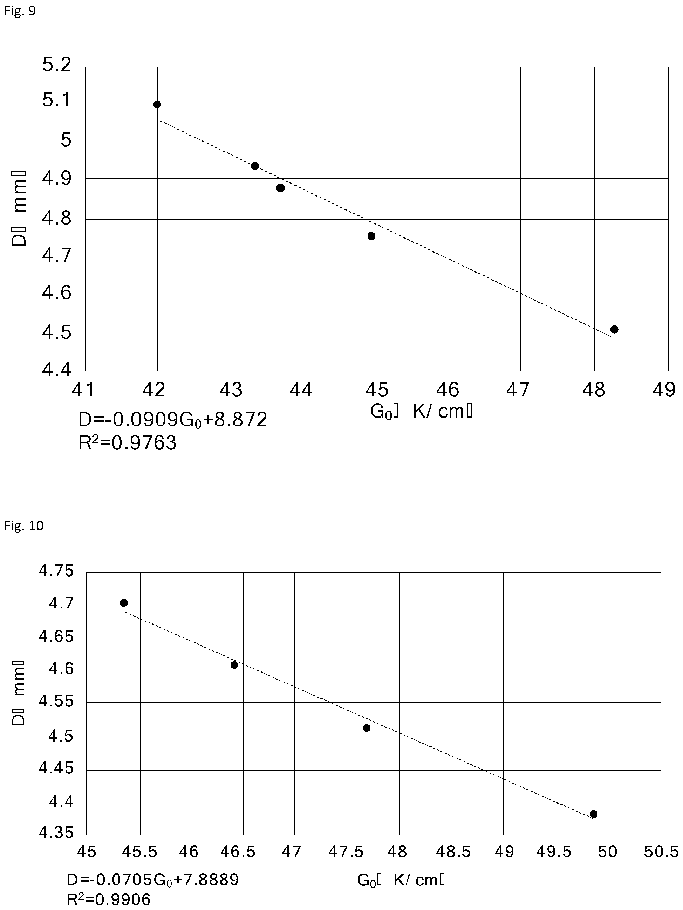

Specifically, within a temperature band from 1645K to 1625K of the first temperature band, Fig. 9 shows a curve of the temperature range in the initial period and mid-period of the equal-diameter growth stage, the linear equation of the width of the temperature band is Dₓ=-0.0909G₀+8.872, and the fitting degree R² of the equation is 0.9763. Fig. 10 shows a curve of the width of the temperature band in the later period of the equal-diameter growth stage, the linear equation of the width of the temperature band is Dₓ = -0.0705G₀+7.8889, and the fitting degree R² of the equation is 0.9906. In the figure, the temperature gradient G₀ at the solid-liquid interface is taken as the abscissa, and the width Dₓ of the temperature band is taken as the ordinate.

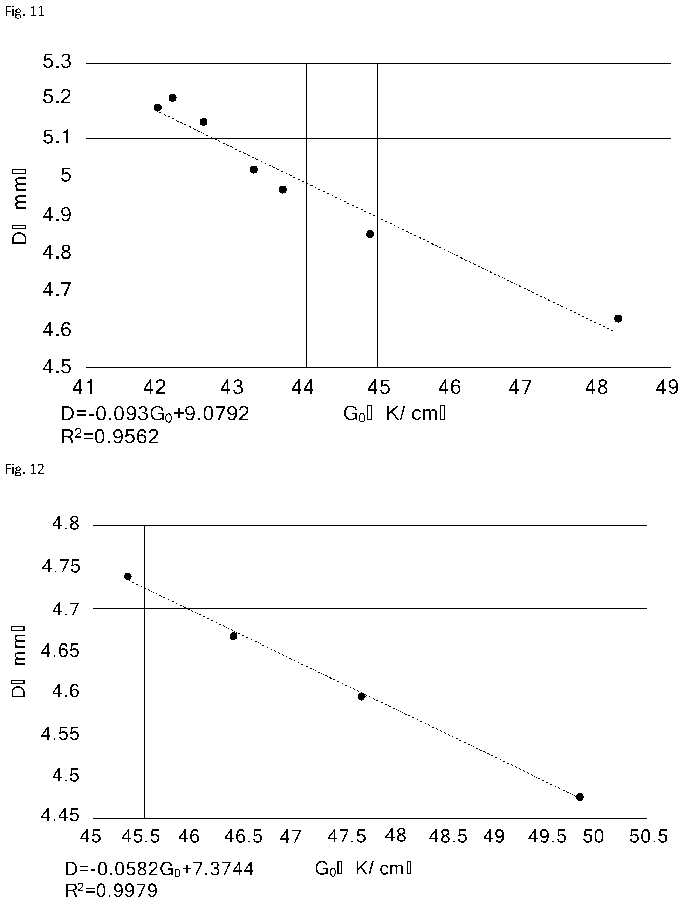

Specifically, within a temperature band from 1625K to 1605K of the first temperature band, Fig. 11 shows a curve of the temperature range in the initial period and mid-period of the equal-diameter growth stage, the linear equation of the temperature range is Dₓ=-0.093G₀+9.0792, and the fitting degree R² of the equation is 0.9562. Fig. 12 shows a curve of the temperature range in the later period of the equal-diameter growth stage, the linear equation of the temperature range is Dₓ=-0.0582G₀+7.3744, and the fitting degree R² of the equation is 0.9979. In the figure, the temperature gradient Go at the solid-liquid interface is taken as the abscissa, and the width Dₓ of the temperature band is taken as the ordinate.

In conclusion, the fitting degrees of the linear equations of the each small temperature range in the first temperature band are all greater than 0.95 or more, indicating that the fitted linear equation is very consistent with actual situations. Therefore, according to the linear equation of the first temperature band, it is guided to adjust the height of the gas flow-guide cylinder from the solid-liquid interface, which can accurately adjust the width of the first temperature band, control the thermal history of the crystal ingot, suppress the growth of the point defects, and control the size of the defects, thereby increasing the yield of growing perfect crystals.

According to another embodiment of the present disclosure, the second temperature band includes temperature bands from 1605K to 1555K, 1555K to 1505K, 1505K to 1455K, 1455K to 1405K, and 1405K to 1355K. The second temperature band includes a plurality of small temperature bands. The difference in the width of the small temperature bands is less than 1.5 mm, and the change in the width of the same temperature band during a growth process is less than 1.0 mm. Furthermore, within the range of the second temperature band in the equal-diameter growth stage, the width of the temperature band is adjusted according to the linear equation D_{y}=m*G₀+b. The G₀ is a temperature gradient at the solid-liquid interface, with a value being 35 to 55 K/cm. The D_{y} is the width of the temperature band, the unit is mm. It may be understood that the width of the second temperature band is adjusted according to the linear equation, in the same period of the equal-diameter growth stage, the difference in the widths of the small temperature bands in the second temperature band is less than 1.5 mm, that is to say, the width of the small temperature bands is almost the same. Meanwhile, in each period of the equal-diameter growth stage, the change in the width of each small temperature band is less than 1.0 mm, that is to say, a variation of the width of each small temperature band is small, and the position of the width of the first temperature band on the crystal ingot may be accurately controlled.

Specifically, in the initial period of the equal-diameter growth stage, D₄ is calculated according to the linear equation D_{y}=m*G₀+b, where m=m₃ and b=b₃, and a distance between the water-cooling jacket and the outer wall of the crystal ingot or cooling water flow in the water-cooling jacket is adjusted according to the D₄, where -0.27≤m₃≤-0.24, and 23.5≤b₃≤25.5, i.e., a theoretical value of the D₄ is calculated according to the linear equation D_{y}=m*G₀+b, where m=m₃ and b=b₃, and then by adjusting the distance between the water-cooling jacket and the outer wall of the crystal ingot, an actual value of the D₄ is equal to the theoretical value of the D₄. It may be understood that, if the actual value of the D₄ is less than the theoretical value, the cooling water flow in the water-cooling jacket is reduced or the distance between the water-cooling jacket and the outer wall of the crystal ingot is increased, then the width D₄ of the temperature band is increased and is closer to the theoretical value. In the later period of the equal-diameter growth stage, D₅ is calculated according to the linear equation D=m*G₀+b, where m=m₄ and b=b₄, and the distance between the water-cooling jacket and the outer wall of the crystal ingot or the cooling water flow in the water-cooling jacket is adjusted according to the D₅, where -0.1≤m₄≤-0.06 and 16.5≤b₄≤17.5, i.e., a theoretical value of the D₅ is calculated according to the linear equation D=m*G₀+b, where m=m₄ and b=b₄, and then by adjusting the distance between the water-cooling jacket and the outer wall of the crystal ingot, an actual value of the D₅ is equal to the theoretical value of the D₅. It may be understood that, if the actual value of the D₅ is greater than the theoretical value, and increasing the cooling water flow in the water-cooling jacket or reducing the distance between the water-cooling jacket and the outer wall of the crystal ingot, the width D₅ of the temperature band is reduced and is closer to the theoretical value. In the mid-period of the equal-diameter growth stage, the width D₆ of the temperature band in the mid-period is between the width D₄ of the temperature band in the initial period and the width D₅ of the temperature band in the later period. It may be understood that, during the process from the initial period to the later period via the mid-period, at the moment of transition from the initial period to the mid-period, the width D₆ of the temperature band in the mid-period is equal to the width D₄ of the temperature band in the initial period; and at the moment of transition from the mid-period to the later period, the width D₆ of the temperature band in the mid-period is equal to the width D₅ of the temperature band in the later period, and the width D₆ of the temperature band changes between the D₄ and the D₅ in the mid-period.

Likewise, by adopting the simulation method for a second temperature width, it can be obtained that the fitting degree of the linear equations of each small temperature range in the second temperature band is greater than 0.95, and will not be repeated here. Therefore, according to the linear equation of the second temperature band, it is guided to adjust the distance between the water-cooling jacket and the outer wall of the crystal ingot or the cooling water flow in the water-cooling jacket, which can accurately adjust the width of the second temperature band and control the thermal history and defect sizes of the crystal ingot, thereby improving the yield of growing perfect crystals.

According to still another embodiment of the present disclosure, within the range of the third temperature band, the width of the temperature band is adjusted according to the linear equation D_{z}=n*L+c, where the D_{z} is the width of the temperature band, the unit is mm, and L is a length of the crystal ingot, the unit is mm. Specifically, in the initial period of the equal-diameter growth stage, according to the linear equation D= n*L+c, where n=n₁ and c=c₁, D₇ is calculated and the cooling water flow rate in the water-cooling jacket is adjusted according to the D₇, where -0.035≤n₁≤-0.015 and 35≤c₁≤45, i.e., a theoretical value of the D₇ is calculated according to the linear equation D=n*L+c, where n=n₁ and c=c₁, and then by adjusting the cooling water flow in the water-cooling jacket, an actual value of the D₇ is equal to the theoretical value of the D₇. It may be understood that, if the actual value of the D₇ is greater than the theoretical value, the cooling water flow in the water-cooling jacket is increased, the width D₇ of the temperature band is increased, which is closer to the theoretical value. In the mid-period and later period of the equal-diameter growth stage, the width of the temperature band remains unchanged, and the width D₈ of the temperature band in the mid-period is equal to the width D₇ of the temperature band in the initial period. It may be understood that, in the equal-diameter growth stage, the width D₈ of the temperature band is equal to the width D₇ of the temperature band at the moment in the initial period at the moment from the initial period to the mid-period, and in the mid-period and later period of the stage, the width D₈ of the temperature band always maintains unchanged.

Likewise, by adopting the simulation method for a third temperature width, it can be obtained that the fitting degree of the linear equations of the third temperature band is greater than 0.95, and will not be repeated here. Therefore, according to the linear equation of the third temperature band, it is guided to adjust the cooling water flow in the water-cooling jacket, which can accurately adjust the width of the third temperature band, and control the thermal history and defect sizes of the crystal ingot, thereby improving the yield of growing perfect crystals.

In conclusion, by accurately controlling the width of the temperature band of the crystal ingot, the nucleation and size of microdefects are effectively suppressed, and the yield of growing the perfect crystals is increased by 10% to 20%.

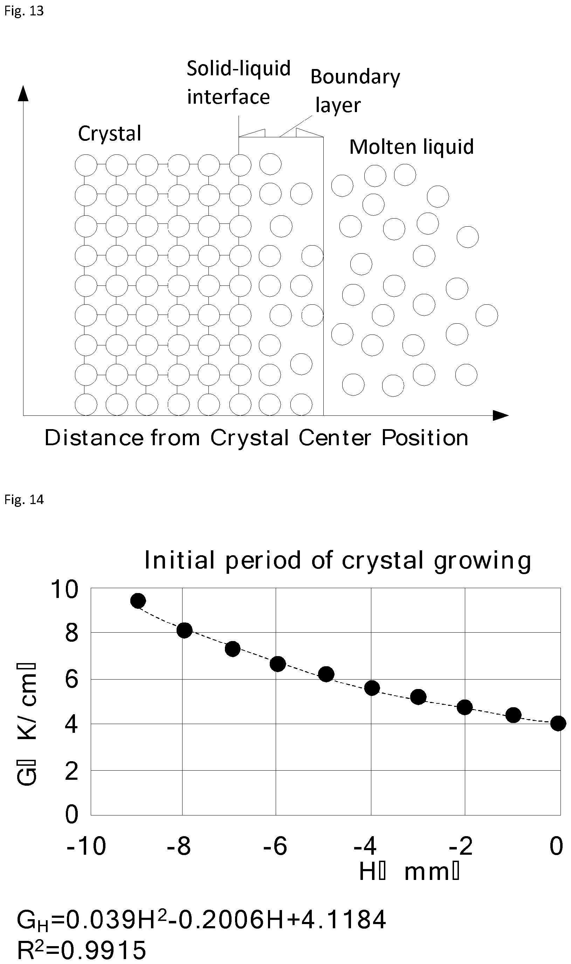

Further, according to the crystal growth theory, when the liquid phase changes to the solid phase and grows crystals, there is a boundary layer between the solid-liquid interface and molten liquid and the boundary layer has a transport effect on the interface. The crystal growing driving force and the temperature gradient of the solid-liquid interface are determined by temperature distribution of the boundary layer, referring to Fig. 13 for details. It may be understood that, the boundary layer is located in a region from the solid-liquid interface to a second reference plane (the second reference plane is an interface 10 mm below the solid-liquid interface). Voronkov's theory points out those interstitial type point defects (I-type point defects) and vacancy type point defects (V-type point defects) are formed near the crystal growing solid-liquid interface, and point defects undergo convective diffusion and recombination at the boundary layer. Therefore, for different thermal field conditions, the crystal growing pulling speed and a gap can be adjusted at same time to realize or optimize the thermal field structure of the boundary layer, and make the temperature gradient distribution of the boundary layer meet requirements for preparing perfect crystals. Furthermore, at present, it is difficult to grow a perfect crystal from a large-size crystal ingot (e.g., 450 mm and above), as the size of the crystal ingot is relatively large, according to the V/G theory, it is difficult to control the axial temperature homogenization of the crystal ingot by controlling only the temperature gradient of the crystal ingot, resulting in a relatively low yield of perfect crystals during the crystal growth process. In this regard, the inventors found that the temperature distribution in the region near the crystal ingot and the temperature gradient distribution near the solid-liquid interface have a direct impact on the growth of large-size crystal ingot.

For this purpose, the inventors proposes that the temperature gradient in the region from the solid-liquid interface to the second reference plane is adjusted (the second reference plane is an interface 10 mm below the solid-liquid interface), while the temperature gradient in the region from the solid-liquid interface to the first reference plane is adjusted.

According to the embodiments of the present disclosure, in the equal-diameter growth stage, G_{H} is obtained according to a linear equation G_{H}=A*H²+B*H+G₀, where A and B are constants, the Go is the temperature gradient at the solid-liquid interface, with the value being 35 to 55 K/cm, H is a height relative to the solid-liquid interface, with a value being -10 to 0 mm, and the G_{H} is an axial temperature gradient of a boundary layer at the height H from the solid-liquid interface, the unit is K/cm.

A temperature gradient is adjusted to the G_{H} in a region from the solid-liquid interface to a second reference plane. The second reference plane is an interface 10 mm below the solid-liquid interface.

Therefore, by quantitatively controlling the temperature gradient in the region from the solid-liquid interface to the first reference plane and the temperature gradient in the region from solid-liquid interface to the second reference plane, that is, the temperature gradient in the region from the first reference plane to the second reference plane at the solid-liquid interface is accurately controlled, and the temperature gradients in the regions above and below the solid-liquid interface directly affects the formation concentration of point defects.

According to the embodiments of the present disclosure, in order to accurately control the temperature gradients in the regions from the solid-liquid interface to the first reference plane and in the regions from the solid-liquid interface to the second reference plane, corresponding to the initial period, mid-period, and the later period of the equal-diameter growth stage, the temperature gradient is respectively optimized in the present disclosure.

Specifically, in the initial period of the equal-diameter growth stage, G_{H1} is calculated according to a linear equation G_{H}=A*H²+B*H+G₀, where A=A₁ and B=B₁, Gₕ₁ is simultaneously calculated according to the equation Gₕ=k*h+G₀, where k=k₁, a pulling speed of the crystal ingot is adjusted to be v₁ and a gap is adjusted to be d₁ according to the G_{H1} and the Gₕ₁, where the A₁, B₁, k₁, v₁, and d₁ meet: 0.03≤A₁≤0.05, -0.3≤B₁≤-0.1, -0.12≤k₁≤-0.1, 0.4≤v₁≤0.8 mm/min, and 50≤d₁≤52 mm, i.e., a theoretical value of the G_{H1} is calculated according to the equation G_{H}=A*H²+B*H+G₀, where A=A₁ and B=B₁, a theoretical value of the Gₕ₁ is calculated according to the equation Gₕ=k*h+G₀, where k=k₁, and then by adjusting the pulling speed v₁ and the gap d₁ within the corresponding range of the v₁ and the d₁, the actual value of the G_{H1} is equal to the theoretical value of the G_{H1}, and an actual value of the Gₕ₁ is equal to the theoretical value of the Gₕ₁. It may be understood that, when the actual values of the G_{H1} and the Gₕ₁ are less than the theoretical values respectively, the gap d₁ is decreased to increase G₀, then the G_{H1} and the Gₕ₁ are close to the theoretical values, and at the same time, the pulling speed may be reduced within the range of the pulling speed v₁, so that point defects formed in the crystal have some time to fully diffuse and recombine to reduce a formation concentration of point defects. In the mid-period of the equal-diameter growth stage, G_{H2} is calculated according to the equation G_{H}=A*H²+B*H+G₀, where A=A₂ and B=B₂, Gₕ₂ is calculated according to the equation Gₕ=k*h+G₀, where k=k₂, the pulling speed of the crystal ingot is adjusted to be v₂ and the gap is adjusted to be d₂ according to the G_{H2} and the Gₕ₂, where the A₂, B₂, k₂, v₂, and d₂ meet:0.01≤A₂≤0.03, -0.2≤B₂≤-0.1, -0.25≤k₂≤-0.23, 0.4≤v₂≤0.6 mm/min, and 52≤d₂≤53 mm, i.e., a theoretical value of the G_{H2} is calculated according to the equation G_{H}=A*H²+B*H+G₀, where A=A₂ and B=B₂, a theoretical value of the Gₕ₂ is calculated according to the equation Gₕ=k*h+G₀, where k=k₂, and then by adjusting the pulling speed v₂ and the gap d₂ within the corresponding range of the v₂ and the d₂, the actual value of the Gₕ₂ is equal to the theoretical value of the Gₕ₂, and the actual value of the G_{H2} is equal to the theoretical value of the G_{H2}. It may be understood that, when the actual values of the G_{H2} and the Gₕ₂ are greater than the theoretical values respectively, the gap d₂ is increased to decrease G₀, and the G_{H2} and the Gₕ₂ are close to the theoretical values, and at the same time, the pulling speed may be reduced within the range of the pulling speed v₂, so that point defects formed in the crystal have some time to fully diffuse and recombine to reduce the formation concentration of point defects. In the later period of the equal-diameter growth stage, G_{H3} is calculated according to the equation G_{H}=A*H²+B*H+G₀, where A=A₃ and B=B₃, Gₕ₃ is calculated according to the equation Gₕ=k*h+G₀, where k=k₃, the pulling speed of the crystal ingot is adjusted to be v₃ and the gap is adjusted to be d₃ according to the Gₕ₃ and the G_{H3}, where the A₃, B₃, k₃, v₃, and d₃ meet: 0.01≤A₃≤0.03, -0.2≤B₃≤-0.1, -0.16≤k₃≤0.14, 0.6≤v₃≤0.8 mm/min, and 54≤d₃≤55 mm, i.e., a theoretical value of the G_{H3} is calculated according to the equation G_{H}=A*H²+B*H+G₀, where A=A₃ and B =B₃, a theoretical value of the Gₕ₃ is calculated according to the equation Gₕ=k*h+G₀, where k=k₃, and then by adjusting the pulling speed v₃ and the gap d₃ within corresponding range of the v₃ and the d₃, an actual value of the Gₕ₃ is equal to the theoretical value of the Gₕ₃, and an actual value of the G_{H3} is equal to the theoretical value of the G_{H3}. It may be understood that, when the actual values of the G_{H3} and the Gₕ₃ are less than the theoretical values respectively, the gap d₃ is decreased to increase G₀, and the Gₕ₃ and the G_{H3} are close to the theoretical value, and at the same time, the pulling speed v₃ may be reduced within the range of the pulling speed, so that point defects formed in the crystal have some time to fully diffuse and recombine to reduce the formation concentration of point defects. Therefore, by quantitatively controlling the temperature gradient in the region from the solid-liquid interface to the first reference plane and the temperature gradient in the region from solid-liquid interface to the second reference plane, I-type point defects and V-type point defects formed during the crystal growth process are fully diffused and recombined at the solid-liquid interface, so that a formation concentration of point defects is reduced, the size of microdefects is controlled, and the width of perfect crystal window is increased. Furthermore, the method is particularly suitable for the growth of large-diameter crystal ingots, and the yield of perfect crystals of the large-diameter crystal ingots may be improved as well.

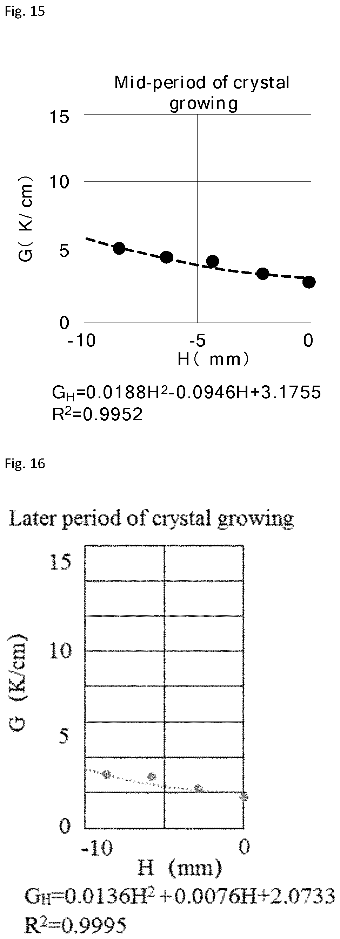

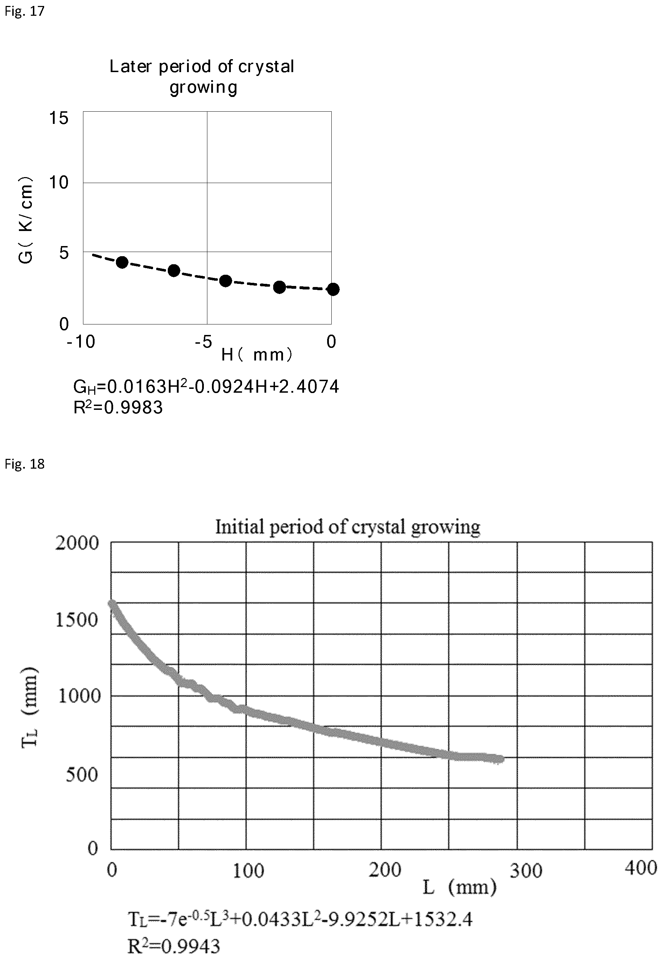

Further, in order to verify the fit performance of the linear equation, an axial temperature gradient near the solid-liquid interface and a height relative to the solid-liquid interface are plotted at periods of different growth stages in the region from the solid-liquid interface to the second reference plane. As shown in Fig. 14, in the region from the solid-liquid interface to the second reference plane, in the initial period of the equal-diameter growth stage (the length of the crystal ingot is 400 mm), a curve is plotted by taking a height H relative to the solid-liquid interface as the abscissa and taking the axial temperature gradient G_{H} near the solid-liquid interface as the ordinate, the equation is G_{H}=0.039H²-0.2006H+4.1184, and a fitting degree R² of the equation is 0.9915. As shown in Fig. 15, in the mid-period of the equal-diameter growth stage, (the length of the crystal ingot is 700 mm), the curve is plotted by taking the height H relative to the crystal growing interface as the abscissa and taking the axial temperature gradient G_{H} near the solid-liquid interface as the ordinate, the equation is G_{H}=0.0188H²-0.0946H+3.1755, and the fitting degree R² of the equation is 0.9952. As shown in Figs. 16 and 17, in the later period of the equal-diameter growth stage (the lengths of the crystal ingots respectively are 1000 mm and 1300 mm), the curve is plotted by taking the height H relative to the solid-liquid interface as the abscissa and taking the axial temperature gradient G_{H} near the solid-liquid interface as the ordinate, the equation with the length of the crystal ingot being 1000 mm is G_{H} =0.0136H²+0.0076H+2.0733, the fitting degree R² of the equation is 0.9995, the equation with the length of the crystal ingot being 1300 mm is G_{H}=0.0163H²-0.0924H+2.4074, and the fitting degree R² of the equation is 0.9983. In conclusion, the fitting degree of each of the above equations is greater than 0.99, indicating that the fitted equation is very consistent with the actual situation. Therefore, by correspondingly adjusting the pulling speed and the gap according to the equation, the axial temperature gradients in the region from the solid-liquid interface to the first reference plane and in the region from the solid-liquid interface to the second reference plane can effectively reduce the concentration of point defects.

It is to be noted that, if the value of the height H relative to the solid-liquid interface is negative, it means that it is located below the solid-liquid interface and its height from the interface is |H|; otherwise, if the value of the height h relative to the solid-liquid interface is positive, it means that it is located above the solid-liquid interface and its height from the interface is h.

According to the embodiments of the present disclosure, in order to further improve the quality of a crystal and the yield of perfect crystals, in the region from the solid-liquid interface to the second reference plane: in the initial period of the equal-diameter growth stage, an temperature gradient variation △G_{c} in the axial direction at a central position of the boundary layer is controlled to be 2 to 3 K/cm, an temperature gradient variation △Gₑ in the axial direction at an edge position of the boundary layer is controlled to be 3.5 to 5.5 K/cm, and the radial temperature gradient Gᵣ of the boundary layer is controlled to be not greater than 2 K/ cm. In the mid-period of the equal-diameter growth stage, the temperature gradient variation △G_{c} in the axial direction at the central position of the boundary layer is controlled to be 4 to 6 K/cm, the temperature gradient variation △Gₑ in the axial direction at the edge position of the boundary layer is controlled to be not greater than 5.4 K/cm, and the radial temperature gradient Gᵣ of the boundary layer is controlled to be not greater than 4 K/cm. In the later period of the equal-diameter growth stage, the temperature gradient variation △G_{c} in the axial direction at the central position of the boundary layer is controlled to be 2 to 3 K/ cm, the temperature gradient variation △Gₑ in the axial direction at the edge position of the boundary layer is controlled to be 3.5 to 5.5 K/cm, and the radial temperature gradient Gᵣ of the boundary layer is controlled to be not greater than 2 K/cm. In the region from the solid-liquid interface to the second reference plane, at different periods of the equal-diameter growth stage, by controlling the temperature gradient variations in the axial direction and radial temperature gradients at the central position and the edge position of the boundary layer, the uniform temperature gradients distribution in the region below the solid-liquid interface ensures that the shape of the solid-liquid interface is close to a plane, which can improve the yield of perfect crystals, wherein the boundary layer is located in the region from the solid-liquid interface to the second reference plane.

According to the embodiments of the present disclosure, in the present disclosure, the method further includes, calculating T_{L} according to an equation T_{L}=g*L³+f*L²+q*L+T₀, where g, f, and q are constants in the region from the solid-liquid interface to its upper side, To is an average temperature at a triple point, the unit is K/cm, L is a height relative to the solid-liquid interface, with a value being 0 to 300 mm, and T_{L} is a temperature of an area near the crystal ingot at the distance L from the solid-liquid interface, the unit is K/ cm. Therefore, by quantitatively distributing the temperatures of the area near the crystal ingot, the growth of microdefects is suppressed by optimizing a thermal field distribution near the crystal ingot, and the yield of preparing perfect crystals is improved. Furthermore, it is to be noted that, "the area near the crystal ingot" here is the central area between a wall of the crystal ingot and an inner wall of the water-cooling jacket.

Specifically, T_{L1} is calculated according to an equation T_{L}=g*L³+f*L²+q*L+T₀, where g=g₁, f=f₁, and q=q₁, and gas flow (the gas flow ranges from 90 sL/pm to 120 sL/pm) near the crystal ingot is adjusted according to the T_{L1}, where a value of g₁ is -8e^{-0.5} to -7e^{-0.5}, a value of f₁ is 0.0411 to 0.0477, and a value of q₁ is -10.309 to -9.6535, i.e., a theoretical value of the T_{L1} is calculated according to the equation T_{L}=g*L³+f*L²+q*L+T₀, where g=g₁, f=f₁, and q=q₁, and then by adjusting the gas flow near the crystal ingot, an actual value of the T_{L1} is equal to the theoretical value of the T_{L1}. It may be understood that, when the actual value of the T_{L1} is greater than the theoretical value, the gas flow rate near the crystal ingot is increased so that the T_{L1} is close to the theoretical value; otherwise, when the actual value of the T_{L1} is less than the theoretical value, the gas flow near the crystal ingot is reduced so that the T_{L1} is close to the theoretical value.

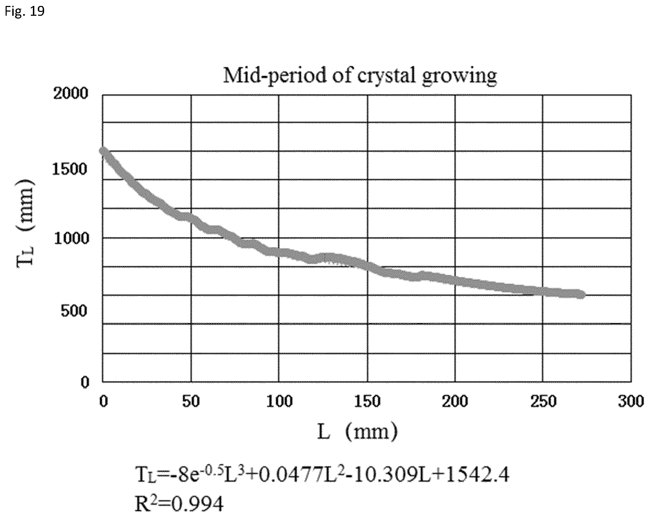

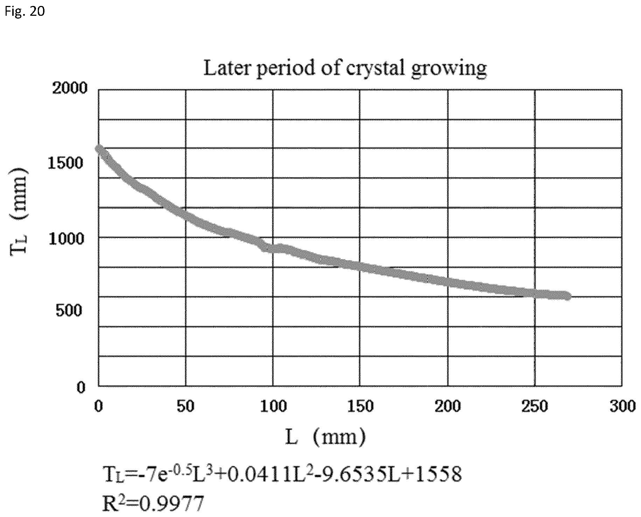

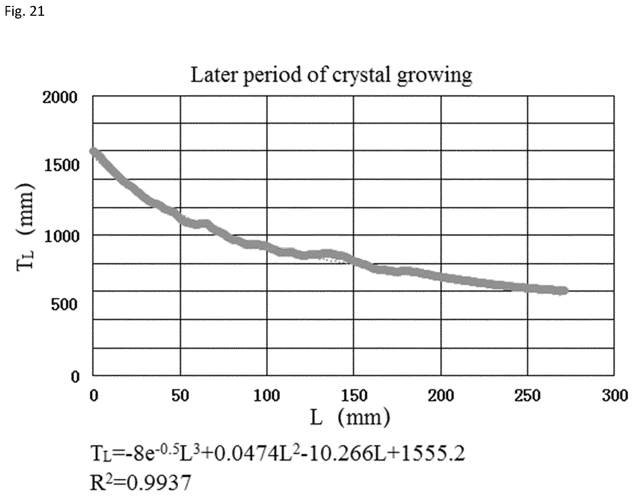

Further, in order to verify the fit performance of the linear equation, the temperature of the area near the crystal ingot and a height relative to the solid-liquid interface are plotted at different crystal growing stages in the region from the crystal growing solid-liquid interface to the second reference plane. As shown in Fig. 18, in the initial period of the equal-diameter growth stage (a length of the crystal ingot is 400 mm), a curve is plotted by taking the height L relative to a crystal growing solid-liquid interface as the abscissa and taking the temperature T_{L} of the area near the crystal ingot as the ordinate, the equation is T_{L} = -7e^{-0.5}L³+0.0433L²-9.9252L+1532.4, and a fitting degree R² of the equation is 0.9943. As shown in Fig. 19, in the mid-period of the equal-diameter growth stage (the length of the crystal ingot is 700 mm), the curve is plotted by taking the height L relative to the solid-liquid interface as the abscissa and taking the temperature T_{L} of the area near the crystal ingot as the ordinate, the equation is T_{L} = -8e^{-0.5}L³+0.0477L²-10.309L+1542.4, and the fitting degree R² of the equation is 0.994. As shown in Figs. 20 and 21, in the later period of the equal-diameter growth stage (the lengths of the crystal ingots respectively are 1000 mm and 1300 mm), the curve is plotted by taking the height L relative to the solid-liquid interface as the abscissa and taking the temperature T_{L} of the area near the crystal ingot as the ordinate, the equation corresponding to the length of the crystal ingot being 1000 mm is T_{L} = -7e^{-0.5}L³+0.0411L²-9.6535L+1558, the fitting degree R² of the equation is 0.9977, the equation corresponding to the length of the crystal ingot being 1300 mm is T_{L}=-8e^{-0.5}L³+0.0474L²-10.266L+1555.2, and the fitting degree R² of the equation is 0.9937. Likewise, the fitting degree of each of the above equations is greater than 0.99, indicating that the fitted equation is very in line with actual situations. Therefore, according to the equation to adjust the gas flow rate near the crystal ingot is correspondingly adjusted, the temperature distribution of the area near the crystal ingot may be accurately controlled. This further affects the distribution of the temperature bands of the crystal ingot, further suppresses the size of microdefects, and improves the yield of perfect crystals.

In conclusion, by accurately controlling the temperature gradients of the areas above and below the solid-liquid interface and adjustment of the temperature distribution near the crystal ingot, the formation concentration of point defects is effectively reduced, and the size of the micro defects are further suppressed, the yield of perfect crystals is increased by 10% to 20%.

According to another aspect of the present disclosure, the present disclosure provides a silicon crystal. According to the embodiments of the present disclosure, the silicon crystal is obtained through preparation by the above-mentioned method. Therefore, the silicon crystal has higher quality. It may be understood that, the proportion of windows belonging to perfect crystals in this silicon crystal is large.

The present disclosure is described below with reference to specific embodiments. It should be noted that, these embodiments are merely descriptive and do not limit the present disclosure in any way.

### Embodiment 1

In an equal-diameter growth stage, a temperature gradient Gₕ in an area from a solid-liquid interface to a reference plane and the width of a temperature band of a crystal ingot are adjusted according to the following method, wherein a value of G₀ is 35 to 55 K/cm.

In an initial period of the equal-diameter growth stage, Gₕ₁ is calculated according to the linear equation Gₕ =k*h+G₀, where k=k₁, and a pulling speed of the crystal ingot is adjusted to be v₁ and a gap is adjusted to be d₁ according to the Gₕ₁, where -0.12≤k₁≤-0.1, 0.4≤v₁≤0.8 mm/min, and 50≤d₁≤52 mm. At the same time, the temperature gradient △G_{c} in the axial direction of the central position of the crystal ingot is controlled to be 0.2 to 1 K/cm, the temperature gradient △Gₑ in the axial direction of the edge position of the crystal ingot is controlled to be 5 to 10 K/cm, and the radial temperature gradient Gᵣ of the crystal ingot is controlled to be not greater than 6 K/cm. In addition, within a range from 1685K to 1605K of a first temperature band in the equal-diameter growth stage, D₁ is calculated according to a linear equation Dₓ= m*G₀+b, where m=m₁ and b=b₁, and the height of the gas flow-guide cylinder from the solid-liquid interface is adjusted according to the D₁, where -0.1≤m₁≤-0.09 and 9≤b₁≤9.1; within a range from 1605K to 1355K of a second temperature band in the equal-diameter growth stage, D₄ is calculated according to a linear equation D_{y}=m*G₀+b, where m=m₃ and b=b₃, and the distance between the water-cooling jacket and an outer wall of the crystal ingot or cooling water flow in the water-cooling jacket is adjusted according to the D₄, where -0.27≤m₃≤-0.24, and 23.5≤b₃≤25.5; within a range from 1355K to 955K of a third temperature band in the equal-diameter growth stage, a width of the temperature band is adjusted according to a linear equation D_{z}=n*L+c, D₇ is calculated by taking n=n₁ and c=c₁, and the cooling water flow in the water-cooling jacket is adjusted according to the D₇, where -0.035≤n₁≤-0.015 and 35≤c₁≤45.

In a mid-period of the equal-diameter growth stage, Gₕ₂ is calculated according to the linear equation Gₕ= k*h+G₀, where k=k₂, and the pulling speed of the crystal ingot is adjusted to be v₂ and the gap is adjusted to be d₂ according to the Gₕ₂, where -0.25≤k₂≤-0.23, 0.4≤v₂≤0.6 mm/min, and 52≤d₂≤53 mm. At the same time, the temperature gradient △G_{c} in the axial direction of the central position of the crystal ingot is controlled to be 2 to 6 K/cm, the temperature gradient △Gₑ in the axial direction of the edge position of the crystal ingot is controlled to be 5 to 10 K/cm, and the radial temperature gradient Gᵣ of the crystal ingot is controlled to be not greater than 10 K/cm. In addition, within the range of the first temperature band from 1685K to 1605K in the mid-period, the width D₃ of the temperature band is controlled to be between the width D₁ of the temperature band in the initial period and the width D₂ of the temperature band in a later period; the temperature range D₆ of a second temperature band from 1605K to 1355K is controlled to be between the width D₄ of the temperature band in the initial period and the width D₅ of the temperature band in the later period; and the temperature range D_{z} of a third temperature band from 1355K to 955K is controlled to maintain unchanged, and the width D₇ of the temperature band within the range of the third temperature band in the initial period of the equal-diameter growth stage is controlled to maintain unchanged.

In the later period of the equal-diameter growth stage, Gₕ₃ is calculated according to the linear equation Gₕ =k*h+G₀, where k=k₃, and the pulling speed of the crystal ingot is adjusted to be v₃ and the gap is adjusted to be d₃ according to the Gₕ₃, where the k₃, v₃, and d₃ meet: -0.16≤k₃≤0.14, 0.6≤v₃≤0.8 mm/min, and 54≤d₃≤55 mm. At the same time, the temperature gradient △G_{c} in the axial direction of the central position of the crystal ingot is controlled to be 0.2 to 1 K/cm, the temperature gradient △Gₑ in the axial direction of the edge position of the crystal ingot is controlled to be 5 to 10 K/cm, and the radial temperature gradient Gᵣ of the crystal ingot is controlled to be not greater than 6 K/cm. Within the range from 1685K to 1605K of the first temperature band, D₂ is calculated by taking m=m₂ and b=b₂, and the height of the gas flow-guide cylinder from the solid-liquid interface is adjusted according to the D₂, where -0.09≤m₂≤-0.05 and 7≤b₂≤8.5. Furthermore, within the range from 1605K to 1355K of the second temperature band, D₅ is calculated by taking m=m₄ and b=b₄, and the distance between the water-cooling jacket and the outer wall of the crystal ingot or the cooling water flow in the water-cooling jacket is adjusted according to the D₅, where -0.1≤m₄≤-0.06 and 16.5≤b₄≤17.5. Within the range of the third temperature band from 1355K to 955K, the width D₈ of the temperature band and the width D₇ of the temperature band within the range of the third temperature band in the initial period of the equal-diameter growth stage are controlled to maintain unchanged.

For the part related to the adjustment of the process parameters in the above embodiments, Please refer to the method described in detail above for adjustment, and details will not be repeated here.

### Comparative embodiment 1

A crystal ingot is pulled by using the existing growth apparatus and preparation method, i.e., compared with embodiment processes, the temperature gradient and the temperature band are not controlled.

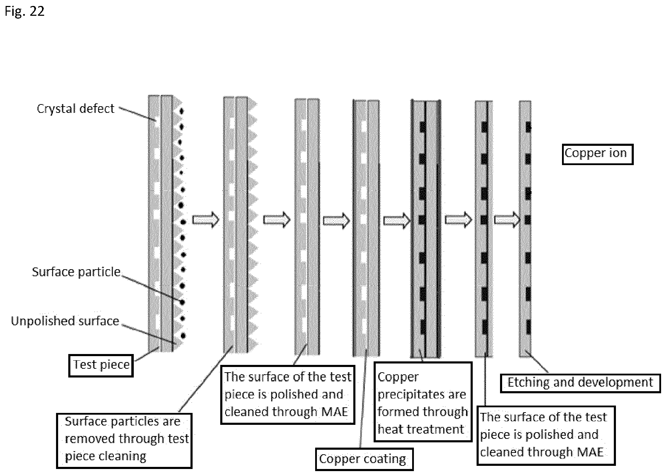

For Embodiment 1 and Comparative embodiment 1, the wafers at length of 180 mm, 340 mm, 650 mm, 950 mm, 1200 mm, and 1350 mm of the crystal ingot are respectively cut, defects of the wafers are characterized by the copper decoration method, and the defect characterization results are shown in Table 1, and the crystal ingots in the embodiments and the comparative embodiments are silicon crystal ingots. Referring to Fig. 22, the specific operations characterized by the copper decoration method includes: firstly washing the test piece with tap water, then cleaning a surface of the test piece with a surfactant to remove surface particles on the surface of the test piece, then polishing and cleaning the surface of the test piece by means of chemical polishing, then coating copper nitrate on the surface of the cleaned test piece, forming copper precipitates on the surface of the test piece after heat treatment, followed by polishing and cleaning the surface of the test piece, and finally etching and developing. As the copper precipitates generate compressive stresses in an area surrounding microdefects, these stresses are relieved by the release of silicon atoms, the released silicon atoms form new dislocations around the copper, and the copper precipitates are subsequently formed on these dislocations. The test piece is a silicon wafer. As many copper precipitates and dislocations form around the microdefects, forming a large area, the microdefects in the wafer may be observed under a microscope. The black portion of the micro-defect map is the perfect area and the white portion is the defect area.

**Table 1 displays the detection results of wafers at various positions of crystal ingot that are obtained from Embodiment 1 and Comparative embodiment 1 using copper decoration method.**

| Wafer position (mm) | Embodiment 1 | Comparative embodiment 1 |
|---|---|---|
| 180 | I-type defect | V-type defect |
| 340 | Perfect crystal | I-type defect |
| 650 | Perfect crystal | I-type defect |
| 950 | Perfect crystal | I-type defect |
| 1200 | Perfect crystal | I-type defect |
| 1350 | I-type defect | V-type defect |

From the detection results in Table 1, it can be learned that Comparative embodiment 1 adopts the prior art method and the defects in the grown crystal ingot are V-type defects at first, I-type defects in the middle, and V-type defects at the end, and no perfect crystals appear in the entire crystal ingot. Embodiment 1 adopts the preparation method of the present disclosure and the grow crystal ingots have perfect crystals at the length of 340 mm, 650 mm, 950 mm, and 1200 mm and the windows are large (which can be directly seen from the copper decoration defect map), according to the V/G theory, within a certain range of pulling speed( 0.4≤v≤0.8 mm/min), there are perfect crystals in the range of length from 340 mm to 1200 mm. Therefore, the yield of the perfect crystals is improved indeed by adopting the preparation method of the present disclosure.

### Embodiment 2

A crystal ingot of 450 mm is grown, and in the area from the solid-liquid interface to the first reference plane and in the area from the solid-liquid interface to the second reference plane, temperature gradients Gₕ and G_{H} are adjusted by referring to the following equations, where a value of G₀ is 35-55 K/cm.

In an initial period of an equal-diameter growth stage, G_{H1} is calculated by taking A=A₁ and B=B₁ in an equation G_{H}=A*H²+B*H+G₀, Gₕ₁ was calculated by taking k=k₁, a pulling speed of the crystal ingot is adjusted to be v₁ and a gap is adjusted to be d1 according to the Gₕ₁ and the G_{H1}, where the A₁, B₁, k₁, v₁, and d₁ meet: 0.03≤A₁≤0.05, -0.3≤B₁≤-0.1, -0.12≤k₁≤-0.1, 0.4≤v₁≤0.8 mm/min, and 50≤d₁≤52 mm. At the same time, in the area from the solid-liquid interface to the second reference plane, the temperature gradient variation △G_{c} in the axial direction of the central position of a boundary layer is controlled to be 2 to 3 K/ cm,the temperature gradient variation △Gₑ in the axial direction of the edge position of the boundary layer is controlled to be 3.5 to 5.5 K/cm, and the radial temperature gradient Gᵣ of the boundary layer is controlled to be not greater than 2 K/cm. In addition, in the area from the solid-liquid interface to the first reference plane, the temperature gradient variation △G_{c} in the axial direction of the central position in the area is controlled to be 0.2 to 1 K/cm, the temperature gradient variation △Gₑ in the axial direction of the edge position in the area is controlled to be 5 to 10 K/cm, and the radial temperature gradient Gᵣ in the area is controlled to be not greater than 6 K/cm.

In a mid-period of the equal-diameter growth stage, G_{H2} is calculated by the equation G_{H}=A*H²+B*H+G₀, where taking A=A₂ and B=B₂, Gₕ₂ is calculated by taking k=k₂, the pulling speed of the crystal ingot is adjusted to be v₂ and the gap is adjusted to be d₂ according to the Gₕ₂ and the G_{H2}, where the A₂, B₂, k₂, v₂, and d₂ meet: 0.01≤A₂≤0.03, -0.2≤B₂≤-0.1, -0.25≤k₂≤-0.23, 0.4≤v₂≤0.6 mm/min, and 52≤d₂≤53 mm. At the same time, in the area from the solid-liquid interface to the second reference plane, the temperature gradient variation △G_{c} in the axial direction of the central position of the boundary layer is controlled to be 4 to 6 K/cm, the temperature gradient variation △Gₑ in the axial direction of the edge position of the boundary layer is controlled to be not greater than 5.4 K/cm, and the radial temperature gradient Gᵣ of the boundary layer is controlled to be not greater than 4 K/cm. In addition, in the area from the solid-liquid interface to the first reference plane, the temperature gradient variation △G_{c} in the axial direction of the central position in the area is controlled to be 2 to 6 K/cm, the temperature gradient variation △Gₑ in the axial direction of the edge position in the area is controlled to be 5 to 10 K/cm, and the radial temperature gradient Gᵣ in the area is controlled to be not greater than 10 K/cm.

In an later period of the equal-diameter growth stage, G_{H3} is calculated by an equation G_{H}=A*H²+B*H+G₀, where taking A=A₃ and B=B₃, Gₕ₃ is calculated by taking k=k₃, the pulling speed of the crystal ingot is adjusted to be v₃ and the gap is adjusted to be d₃ according to the Gₕ₃ and the G_{H3}, where the A₃, B₃, k₃, v₃, and d₃ meet: 0.01≤A₃≤0.03, -0.2≤B₃≤-0.1, -0.16≤k₃≤0.14, 0.6≤v₃≤0.8 mm/min, and 54≤d₃≤55 mm. At the same time, in the area from the solid-liquid interface to the second reference plane, the temperature gradient variation △G_{c} in the axial direction of the central position of the boundary layer is controlled to be 2 to 3 K/ cm, the temperature gradient variation △Gₑ in the axial direction of the edge position of the boundary layer is controlled to be 3.5 to 5.5 K/cm, and the radial temperature gradient Gᵣ of the boundary layer is controlled to be not greater than 2 K/cm. In addition, in the area from the solid-liquid interface to the first reference plane, the temperature gradient variation △G_{c} in the axial direction of the central position in the area is controlled to be 0.2 to 1 K/cm, the temperature gradient variation △Gₑ in the axial direction of the edge position in the area is controlled to be 5 to 10 K/cm, and the radial temperature gradient Gᵣ in the area is controlled to be not greater than 6 K/cm.

Furthermore, in the area from the solid-liquid interface to its upper part, T_{L1} is calculated according to an equation T_{L}=m*L³+n*L²+q*L+T₀, where m=m₁, n=n₁, and q=q₁, and the gas flow near the crystal ingot is adjusted according to the T_{L1}, where the value of m₁ is -8e^{-0.5} to -7e^{-0.5}, the value of n₁ is 0.0411 to 0.0477, and the value of q₁ is -10.309 to -9.6535.

### Comparative embodiment 2

A crystal ingot of 450 mm is pulled by using existing growth apparatus and the preparation method, i.e., compared with the process in Embodiment 2, the temperature gradient near the solid-liquid interface and the temperature near the crystal ingot are not controlled.

For Embodiment 2 and Comparative embodiment 2, the wafers at length of 100 mm, 400 mm, 700 mm, 1000 mm, and 1300 mm of the crystal ingot are respectively cut, the defects of the wafers are characterized by the copper decoration method, the defect characterization results are shown in Table 2, wherein the crystal ingots in the embodiments and the comparative embodiments are silicon crystal ingots.

**Table 2 displays the defect detection results of wafers at various positions of crystal ingot that are obtained from Embodiment 2 and Comparative embodiment 2 using the copper decoration method.**

| Wafer position (mm) | Embodiment 2 | Comparative embodiment 2 |
|---|---|---|
| 100 | I-type defect | V-type defect |
| 400 | Perfect crystal | I-type defect |
| 700 | Perfect crystal | I-type defect |
| 1000 | Perfect crystal | I-type defect |
| 1300 | Perfect crystal | V-type defect |

From the detection results in Table 2, it can be learned that Comparative embodiment 2 adopts the prior art method, and the defects in the grown crystal ingot are V-type defects at first, I-type defects in the middle, and V-type defects at last, and no perfect crystals appear in the entire crystal ingot. Embodiment 2 adopts the preparation method of the present disclosure, and the crystal ingots have perfect crystals at the length of 400 mm, 700 mm, 1000 mm, and 1300 mm, and the windows are large (which can be directly seen from the copper decoration defect map), according to the V/G theory, within a certain range of a pulling speed (0.4≤v≤0.8 mm/min), perfect crystals existed in the range of ingot length from 400 mm to 1300 mm. Therefore, the yield of the perfect crystals is improved indeed by adopting the preparation method of the present disclosure.

In the description of the specification, descriptions referring to the terms "an embodiment," "some embodiments," "embodiment," "specific embodiment," or "some embodiments", mean that specific features, structures, materials, or characteristics described with reference to the implementations or embodiments are included in at least one implementation or embodiment of the present disclosure. In this specification, schematic representations of the above terms do not necessarily refer to the same embodiment or embodiment. In addition, the described particular features, structures, materials or characteristics may be combined in any suitable manner in any one or more embodiments or embodiments. In addition, a person skilled in the art may integrate and combine the different embodiments or embodiments described in this specification and the features of the different embodiments or embodiments without contradiction.

The embodiments of the present disclosure are described above with reference to the drawings, but the present disclosure is not limited to the above specific embodiments, which are merely illustrative rather than restrictive. Under the inspiration of the present disclosure, those of ordinary skill in the art can also make many forms without departing from the scope of the present disclosure and the protection scope of the claims, which all fall within the protection of the present disclosure.

## Claims

1. A method for preparing a single crystal, comprising:
in an equal-diameter growth stage, obtaining Gₕ according to a linear equation Gₕ=k*h+G₀, wherein G₀ is a temperature gradient at a solid-liquid interface, with a value being 35 to 55 K/cm, h is a height relative to the solid-liquid interface, with a value being 0-10 mm, k is a constant, and Gₕ is an axial temperature gradient of a crystal ingot at the height h from the solid-liquid interface, the unit is K/cm; and
adjusting a temperature gradient to Gₕ in an area from the solid-liquid interface to a first reference plane, wherein the first reference plane is an interface 10 mm above the solid-liquid interface.

2. The method according to claim 1, wherein in an initial period of the equal-diameter growth stage, Gₕ₁ is calculated by taking k=k₁, a pulling speed of a crystal ingot is adjusted to v₁ according to the Gₕ₁, and a gap is d1, wherein the k₁, the v₁, and the d₁ meet: -0.12≤k₁≤-0.1, 0.4≤v₁≤0.8 mm/min, and 50≤d₁≤52 mm;
in a mid-period of the equal-diameter growth stage, Gₕ₂ is calculated by taking k=k₂, the pulling speed of the crystal ingot is adjusted to v₂ according to the Gₕ₂, and the gap is d₂, wherein the k₂, the v₂, and the d₂ meet: -0.25≤k₂≤-0.23, 0.4≤v₂≤0.6 mm/min, and 52≤d₂≤53 mm; and
in a later period of the equal-diameter growth stage, Gₕ₃ is calculated by taking k=k₃, the pulling speed of the crystal ingot is adjusted to v₃ according to the Gₕ₃, and the gap is d₃, wherein the k₃, the v₃, and the d₃ meet: -0.16≤k₃≤0.14, 0.6≤v₃≤0.8 mm/min, and 54≤d₃≤55 mm.

3. The method according to claim 2, wherein in the initial period of the equal-diameter growth stage, △G_{c} is controlled to be 0.2 to 1 K/cm, △Gₑ is controlled to be 5 to 10 K/cm, and Gᵣ is controlled to be not greater than 6 K/cm;
in the mid-period of the equal-diameter growth stage, the △G_{c} is controlled to be 2 to 6 K/cm, the △Gₑ is controlled to be 5 to 10 K/cm, and the Gᵣ is controlled to be not greater than 10 K/cm; and
in the later period of the equal-diameter growth stage, the △G_{c} is controlled to be 0.2 to 1 K/cm, the △Gₑ is controlled to be 5 to 10 K/cm, and the Gᵣ is controlled to be not greater than 6 K/cm, wherein
a temperature gradient variation in the axial direction at a central position of the crystal ingot is the △G_{c}, a temperature gradient variation in the axial direction at an edge position of the crystal ingot is the △Gₑ, and a radial temperature gradient of the crystal ingot is the Gᵣ.

4. The method according to claim 1, further comprising adjusting a width of a temperature band on the crystal ingot, wherein the temperature band includes a first temperature band, a second temperature band, and a third temperature band, the first temperature band ranges from 1685K to 1605K, the second temperature band ranges from 1605K to 1355K, and the third temperature band ranges from 1355K to 955K.

5. The method according to claim 4, wherein, in the equal-diameter growth stage, within the range of the first temperature band, the width of the temperature band is adjusted according to a linear equation Dₓ= m*G₀+b, wherein the G₀ is a temperature gradient at the solid-liquid interface, with a value being 35 to 55 K/cm, and the Dₓ is the width of the temperature band, the unit is mm.

6. The method according to claim 5, wherein in the initial period of the equal-diameter growth stage, D₁ is calculated by taking m=m₁ and b=b₁, and a height of a gas flow-guide cylinder from the solid-liquid interface is adjusted according to the D1, wherein -0.1≤m₁≤-0.09, and 9≤b₁≤9.1;
in the later period of the equal-diameter growth stage, D₂ is calculated by taking m=m₂ and b=b₂, and the height of the gas flow-guide cylinder from the solid-liquid interface is adjusted according to the D₂, wherein -0.09≤m₂≤-0.05, and 7≤b₂≤8.5; and
in the mid-period of the equal-diameter growth stage, the width D₃ of the temperature band in the mid-period is between the width D₁ of the temperature band in the initial period and the width D₂ of the temperature band in the later period.

7. The method according to claim 4, wherein, in the equal-diameter growth stage, within the range of the second temperature band, the width of the temperature band is adjusted according to a linear equation D_{y} =m*G₀+b, wherein the G₀ is a temperature gradient at the solid-liquid interface, with a value being 35 to 55 K/cm, and the D_{y} is the width of the temperature band, the unit is mm.

8. The method according to claim 7, wherein in the initial period of the equal-diameter growth stage, D₄ is calculated by taking m=m₃ and b=b₃, and a distance between a water-cooling jacket and an outer wall of the crystal ingot or cooling water flow in the water-cooling jacket is adjusted according to the D₄, wherein -0.27≤m₃≤-0.24, and 23.5≤b₃≤25.5;
in the later period of the equal-diameter growth stage, D₅ is calculated by taking m=m₄ and b=b₄, and the distance between the water-cooling jacket and the outer wall of the crystal ingot or the cooling water flow in the water-cooling jacket is adjusted according to the D₅, wherein -0.1≤m₄≤-0.06, and 16.5≤b₄≤17.5; and
in the mid-period of the equal-diameter growth stage, the width D₆ of the temperature band in the mid-period is between the width D₄ of the temperature band in the initial period and the width D₅ of the temperature band in the later period.

9. The method according to claim 4, wherein, in the equal-diameter growth stage, within the range of the third temperature band, the width of the temperature band is adjusted according to a linear equation D_{z}= n*L+c, wherein the D_{z} is the width of the temperature band, the unit is mm, and L is a length of the crystal ingot, the unit is mm.

10. The method according to claim 9, wherein in the initial period of the equal-diameter growth stage, D₇ is calculated by taking n=n₁ and c=c₁, and cooling water flow in a water-cooling jacket is adjusted according to the D₇, wherein -0.035≤n₁≤-0.015, and 35≤c₁≤45; and
in the mid-period and later period of the equal-diameter growth stage, the width of the temperature band is controlled to maintain unchanged, and the width D₈ of the temperature band in the mid-period is equal to the width D₇ of the temperature band in the initial period.

11. The method according to claim 1, wherein in the equal-diameter growth stage, G_{H} is obtained according to a linear equation G_{H}=A*H²+B*H+G₀, wherein A and B are constants, the G₀ is the temperature gradient at the solid-liquid interface, with the value being 35 to 55 K/cm, H is a height relative to the solid-liquid interface, with a value being -10 to 0 mm, k is a constant, and the G_{H} is an axial temperature gradient of a boundary layer at the height H from the solid-liquid interface, the unit is K/cm; and
a temperature gradient is adjusted to the G_{H} in an area from the solid-liquid interface to a second reference plane, wherein the second reference plane is an interface 10 mm below the solid-liquid interface.

12. The method according to claim 11, wherein in an initial period of the equal-diameter growth stage, G_{H1} is calculated by taking A=A₁ and B=B₁, Gₕ₁ is calculated by taking k=k₁, a pulling speed of the crystal ingot is adjusted to v₁ according to the G_{H1} and the Gₕ₁, and a gap is d₁, wherein the A₁, the B₁, the k₁, the v₁, and the d₁ meet: 0.03≤A₁≤0.05, -0.3≤B₁≤-0.1, -0.12≤k₁≤-0.1, 0.4≤v₁≤0.8 mm/min, and 50≤d₁≤52 mm;
in a mid-period of the equal-diameter growth stage, G_{H2} is calculated by taking A=A₂ and B=B₂, Gₕ₂ is calculated by taking k=k₂, the pulling speed of the crystal ingot is adjusted to v₂ according to the G_{H2} and the Gₕ₂, and the gap is d₂, wherein the A₂, the B₂, the k₂, the v₂, and the d₂ meet: 0.01≤A₂≤0.03, -0.2≤B₂≤-0.1, -0.25≤k₂≤-0.23, 0.4≤v₂≤0.6 mm/min, and 52≤d₂≤53 mm; and
in a later period of the equal-diameter growth stage, G_{H3} is calculated by taking A=A₃ and B=B₃, Gₕ₃ is calculated by taking k=k₃, the pulling speed of the crystal ingot is adjusted to v₃ according to the G_{H3} and the Gₕ₃, and the gap is d₃, wherein the A₃, the B₃, the k₃, the v₃, and the d₃ meet: 0.01≤A₃≤0.03, -0.2≤B₃≤-0.1, -0.16≤k₃≤0.14, 0.6≤v₃≤0.8 mm/min, and 54≤d₃≤55 mm.

13. The method according to claim 12, wherein in the area from the solid-liquid interface to the second reference plane:
in the initial period of the equal-diameter growth stage, a temperature gradient variation △G_{c} in the axial direction at a central position of the boundary layer is controlled to be 2 to 3 K/cm, and a temperature gradient variation △Gₑ in the axial direction at an edge position of the boundary layer is controlled to be 3.5 to 5.5 K/cm;
in the mid-period of the equal-diameter growth stage, the temperature gradient variation △G_{c} in the axial direction at the central position of the boundary layer is controlled to be 4 to 6 K/cm, and the temperature gradient variation △Gₑ in the axial direction at the edge position of the boundary layer is controlled to be not greater than 5.4 K/cm; and
in the later period of the equal-diameter growth stage, the temperature gradient variation △G_{c} in the axial direction at the central position of the boundary layer is controlled to be 2 to 3 K/cm, and the temperature gradient variation △Gₑ in the axial direction at the edge position of the boundary layer is controlled to be 3.5 to 5.5 K/cm, wherein
the boundary layer is located in the area from the solid-liquid interface to the second reference plane.

14. The method according to claim 12 or 13, wherein in the area from the solid-liquid interface to the second reference plane:
in the initial period of the equal-diameter growth stage, a radial temperature gradient Gᵣ of the boundary layer is controlled to be not greater than 2 K/cm;
in the mid-period of the equal-diameter growth stage, a radial temperature gradient Gᵣ of the boundary layer is controlled to be not greater than 4 K/cm; and
in the later period of the equal-diameter growth stage, a radial temperature gradient Gᵣ of the boundary layer is controlled to be not greater than 2 K/cm.

15. The method according to claim 1 or 11, wherein T_{L} is calculated according to an equation T_{L}= g*L³+f*L²+q*L+T₀, wherein g, f, and q are constants, T₀ is an average temperature at the triple point, the unit is K/cm, L is a height relative to the solid-liquid interface, with a value being 0 to 300 mm, and T_{L} is a temperature of an area near the crystal ingot at the distance L from the solid-liquid interface, the unit is K/ cm; and
the area near the crystal ingot is a central area between a wall of the crystal ingot and an inner wall of a water-cooling jacket.

16. The method according to claim 15, wherein T_{L1} is calculated by taking g=g₁, f=f₁, and q=q₁, and gas flow near the crystal ingot is adjusted according to the T_{L1}, wherein a value of g₁ is -8e^{-0.5} to -7e^{-0.5}, a value of f₁ is 0.0411 to 0.0477, and a value of q₁ is -10.309 to -9.6535.

17. A silicon crystal, obtained through preparation by using the method according to any one of claims 1 to 16.
